(19) Europäisches Patentamt
European Patent Office
Office européen des brevets

(11) **EP 2 822 182 B1**

(12) **EUROPEAN PATENT SPECIFICATION**

(45) Date of publication and mention
of the grant of the patent:
**17.08.2016 Bulletin 2016/33**

(51) Int Cl.:
*H03M 13/11* (2006.01)        *H03M 13/29* (2006.01)
*H03M 13/03* (2006.01)        *H03M 13/25* (2006.01)
*H03M 13/15* (2006.01)

(21) Application number: **14171484.0**

(22) Date of filing: **06.06.2014**

(54) **Apparatus and method for improved modulation and coding schemes for broadband satellite communications systems**

Vorrichtung und Verfahren zur verbesserten Modulation und Codierung für breitbandige Satellitenkommunikationssysteme

Appareil et procédé de schémas de modulation et de codage améliorés pour systèmes de communications par satellite à large bande

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.07.2013 US 201313933774**

(43) Date of publication of application:
**07.01.2015 Bulletin 2015/02**

(73) Proprietor: **Hughes Network Systems, LLC Germantown, MD 20876 (US)**

(72) Inventors:
• **Eroz, Mustafa**
  **Germantown, MD Maryland 20874 (US)**
• **Lee, Lin-Nan**
  **Potomac, MD Maryland 20854 (US)**

(74) Representative: **Körfer, Thomas Mitscherlich PartmbB Patent- und Rechtsanwälte Sonnenstrasse 33 80331 München (DE)**

(56) References cited:
• **DVB ORGANIZATION: "Sx_very_low_SNR_intermediate.docx", DVB, DIGITAL VIDEO BROADCASTING, C/O EBU - 17A ANCIENNE ROUTE - CH-1218 GRAND SACONNEX, GENEVA - SWITZERLAND, 22 July 2013 (2013-07-22), XP017841241,**
• **DVB ORGANIZATION: "TM-S20281_Annex-M-Comments.docx", DVB, DIGITAL VIDEO BROADCASTING, C/O EBU - 17A ANCIENNE ROUTE - CH-1218 GRAND SACONNEX, GENEVA - SWITZERLAND, 7 October 2013 (2013-10-07), XP017845061,**
• **DVB ORGANIZATION: "TM4941_Draft_S2-X_Specification.pdf", DVB, DIGITAL VIDEO BROADCASTING, C/O EBU - 17A ANCIENNE ROUTE - CH-1218 GRAND SACONNEX, GENEVA - SWITZERLAND, 21 October 2013 (2013-10-21), XP017842249,**
• **ANONYMOUS: 'Digital Video Broadcasting (DVB);Second generation framing structure, channel coding and modulation systems for Broadcasting,Interactive Services, News Gathering and other broadband satellite applications (DVB-S2)', [Online] vol. 302 307, no. V1.2.1, 01 August 2009, pages 22 - 28,37, XP002678089 ETSI EN 302 307 V1.2.1, SOPHIA ANTIPOLIS CEDEX - FRANCE Retrieved from the Internet: <URL:http://www.etsi.org/deliver/etsi_en/30 2300_302399/302307/01.02.01_60/ en_302307v010201p.pdf> [retrieved on 2012-06-19]**

**Description**

BACKGROUND

Over recent decades, developments in data communications technologies have continued to provide enhanced multimedia services (e.g., voice, data, video, etc.) to end-users. Such communications technologies encompass various delivery platforms, including terrestrial wire-line, fiber and wireless communications and networking technologies, and satellite communications and networking technologies. Further, in recent years, the proliferation of mobile communications has spurred an exponential growth in the provision of such enhanced multimedia services over mobile communications networks (both terrestrial and satellite based). As part of the continued evolution of such communications platforms and supporting technologies, the Digital Video Broadcasting (DVB) organization was formed (as an industry-led, global consortium of broadcasters, manufacturers, network operators, software developers, regulatory bodies and others) to advance the design of open interoperable standards for the global delivery of digital media and broadcast services.

As part of the standardization process for digital media and broadcast services, the DVB organization managed the adoption and publication of the DVB-S2 standard via recognized standards setting organizations (e.g., ETSI and TIA). DVB-S2 is a digital satellite transmission system standard covering framing structure, channel coding and modulation systems, designed for broadcast services (for standard and high definition television), interactive services (e.g., Internet access for consumer applications), and other broadband satellite applications. DVB-S2 represents a flexible standard, covering a variety of data and multimedia services delivered over satellite communications systems. The DVB-S2 standard covers various technological features, such as a flexible input stream adapter (suitable for operation with single and multiple input streams of various formats), a robust forward error correction coding (FEC) system based on low-density parity check (LDPC) codes concatenated with Bose Chaudhuri Hocquenghem (BCH) codes, a wide range of code rates (from 1/4 up to 9/10), four signal constellations (ranging in spectrum efficiency from 2 bit/s/Hz to 5 bit/s/Hz), and adaptive coding and modulation (ACM) functionality (optimizing channel coding and modulation on a frame-by-frame basis).

Since its inception, the DVB-S2 standard has been adopted globally as a predominant standard for broadcast, interactive and other broadband applications and services over satellite communications networks. Currently, there are applications and services for terminals, particularly in the field of mobile communications, that require operation at lower signal-to-noise ratios ($E_s/N_0$), down to approximately -9 dB to -10 dB. The current modulation and coding schemes (e.g., the modulation and coding schemes of the DVB-S2 standard), however, support operation down to $E_s/N_0$ ratios of only about -3 dB, and thus are unable to support the operational requirements for such current mobile and other low signal-to-noise ratio (SNR) terminals (e.g., below -3 dB). Further, the modulation and coding schemes of the current DVB-S2 standard ($E_s/N_0$ ratios within the range of approximately -3 dB to 15.5 dB) lack sufficient granularity to meet the requirements of terminals in the growing field of broadcast, interactive and other broadband applications and services over satellite communications networks.

What is needed, therefore, are systems and methods for providing modulation and coding schemes that support current and future communications services and applications for terminals with operational requirements at relatively low SNR and terminals, and to provide modulation and coding schemes that offer finer granularity (among existing modulation and coding schemes) within an intermediate operational range.

SOME EXEMPLARY EMBODIMENTS

The present invention advantageously addresses the foregoing requirements and needs, as well as others, by providing a system and methods for providing modulation and coding schemes that support current and future communications services and applications for terminals with operational requirements at relatively low $E_s/N_0$ ratios (e.g., within the operational range of approximately -3 dB to -10 dB), and to provide modulation and coding schemes that offer finer granularity within an intermediate operational range of $E_s/N_0$ ratios (e.g., approximately -3 dB to 15.5 dB).

The invention is defined by the independent claims 1 and 7. The dependent claims comprise further developments of the invention.

According to an exemplary embodiment, a method comprises encoding, by a processor of a device, a source data sequence of information bits based on a predetermined structured parity check matrix of a Low Density Parity Check (LDPC) code, wherein the encoding is performed based on frames of the source data sequence, each frame being of a length of $k_{ldpc}$ information bits ($i_0, i_1, ..., i_{k_{ldpc}-1}$), and the output of the encoding comprises coded LDPC frames each being $n_{ldpc}$ coded bits in length. The structured parity check matrix is represented by tabular information (a code table) of a format wherein each row represents occurrences of one values within a respective column of the parity check matrix, and the columns of the parity check matrix are derived according to a predetermined operation based on the respective rows of the tabular information, and wherein the code table comprises one of a selection of new LDPC code designs (each represented by a respective code table). According to the method, the encoding wherein the encoding comprises generating $n_{ldpc}$ - $k_{ldpc}$ parity bits ($p_0$, $p_1$,...,$p_{n_{ldpc}-k_{ldpc}-1}$) for each frame of the source data sequence, wherein the generation of the parity bits comprises: initializing parity bit accumulators for $p_0$, $p_1$,...,$p_{n_{ldpc}-k_{ldpc}-1}$ to zero; accumulating information bit $i_0$ at parity bit accumulator addresses specified in the first row of the table; for the next group of $m$ - 1 information bits, $iy$ ($y$ = 1, 2, ... , $m$ - 1), accumulating each information bit at parity bit accumulator addresses {$x$ + ($y$ mod $m$) $_*q$} $mod$ ($n_{ldpc}$ - $k_{ldpc}$), wherein $x$ denotes an address of a parity bit accumulator corresponding to the information bit $i_0$, and $q$ is a code-rate dependent constant ($q$ = ($n_{ldpc}$ - $k_{ldpc}$)/$m$), and wherein $m$ is a code-dependent constant and $k_{ldpc}$ = $R$ * $n_{ldpc}$ (where $R$ is the code rate); accumulating $i_m$ at parity bit accumulator addresses specified in the second row of the table, and, in a similar manner as for the group of $m$ - 1 information bits (above), accumulating each information bit of the next group of $m$ - 1 information bits $i_z$, $z$ = ($m$ + 1, $m$ + 2,... , 2$m$) at {$x$ + ($z$ mod $m$)* $q$} $mod$ ($n_{ldpc}$ - $k_{ldpc}$), wherein $x$ denotes the address of the parity bit accumulator corresponding to the information bit $i_m$ (the entries of the second row of the table); in a similar manner, for each subsequent group of $m$ information bits, accumulating the information bits at parity bit addresses based on a next row of the table; and after all of the information bits of the frame are accumulated, performing operations according to $p_i$ = $p_i$ ⊕ $p_{i-1}$, wherein for $i$ = 1, 2, ..., ($n_{ldpc}$ - $k_{ldpc}$ - 1), each $p_i$ resulting from the operation for a given $i$ is equal to the parity bit $p_i$.

According to a further exemplary embodiment, the method further comprises modulating the coded FEC frames according to a selected modulation scheme, wherein the selected modulation scheme comprises one of the following modulation types: $\pi$/2 BPSK (Binary Phase Shift Keying), QPSK (Quadrature Phase Shift Keying), 8-PSK (Phase Shift Keying), 16-APSK (Amplitude Phase Shift Keying), and 32-APSK, wherein, in the case of $\pi$/2 BPSK or QPSK, the coded FEC frames are not interleaved.

Still other aspects, features, and advantages of the present invention are readily apparent from the following detailed description, simply by illustrating a number of particular embodiments and implementations, including the best mode contemplated for carrying out the present invention. The present invention is also capable of other and different embodiments, and its several details can be modified in various obvious respects. Accordingly, the drawing and description are to be regarded as illustrative in nature, and not as restrictive.

BRIEF DESCRIPTION OF THE DRAWINGS

The present invention is illustrated by way of example, and not by way of limitation, in the figures of the accompanying drawings and in which like reference numerals refer to similar elements and in which:

**FIG. 1A** illustrates a communications system capable of employing modulation and coding protocols, in accordance with exemplary embodiments of the present invention;

**FIG. 1B** illustrates a satellite communications system capable of employing modulation and coding protocols, in accordance with exemplary embodiments of the present invention;

**FIG. 2A** illustrates a block diagram of an exemplary transmitter configured to operate in the systems of **FIGs. 1A and 1B,** in accordance with exemplary embodiments of the present invention;

**FIG. 2B** illustrates a block diagram of an exemplary receiver configured to operate in the systems of **FIGs. 1A and 1B,** in accordance with exemplary embodiments of the present invention;

**FIG. 3A** illustrates the bit interleaving scheme for the 8PSK modulation formats (for all rates except rate 3/5) of the DVB-S2 standard for the normal FEC Frame length;

**FIG. 3B** illustrates the bit interleaving scheme for the 8PSK modulation formats (for rate 3/5 only) of the DVB-S2 standard for the normal FEC Frame length;

**FIG. 4** illustrates a prior art 32APSK (4+12+16) signal constellation;

**FIG. 5** illustrates simulated performance curves for the provided modulation and coding schemes over an AWGN channel, in accordance with exemplary embodiments of the present invention;

**FIG. 6** illustrates a flow chart of an exemplary process for encoding and modulating a source data sequence of information bits, in accordance with exemplary embodiments of the present invention;

**FIG. 7** illustrates a flow chart of an exemplary process for demodulating and decoding a received data signal transmission to replicate a source data sequence of information bits that was encoded and modulated, in accordance with exemplary embodiments of the present invention;

**FIG. 8** illustrates a block diagram of a chip set that can be utilized in implementing communications system protocols, according to exemplary embodiments of the present invention.

DETAILED DESCRIPTION

A system and methods for communications system protocols to support communications services and applications over relatively low signal-to-noise ratio ($E_s/N_0$) links, is described. In the following description, for the purposes of explanation, numerous specific details are set forth in order to provide a thorough understanding of the invention. It is apparent, however, that the invention may be practiced without these specific details or with an equivalent arrangement. In other instances, well known structures and devices are shown in block diagram form in order to avoid unnecessarily obscuring the invention.

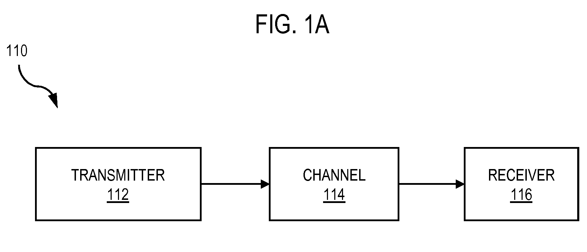

**FIG. 1A** illustrates a communications system capable of employing modulation and coding protocols, in accordance with exemplary embodiments of the present invention. With reference to **FIG. 1A**, a broadband communications system 110 includes one or more transmitters 112 (of which one is shown) that generate signal waveforms for transmission to one or more receivers 116 (of which one is shown). The signal waveforms are transmitted across a communications channel 114, which (for example) may comprise a channel of a terrestrial, wireless terrestrial or satellite communications system. In this discrete communications system 110, the transmitter 112 has a signal source that produces a discrete set of data signals, where each of the data signals is transmitted over a corresponding signal waveform. The discrete set of data signals may first be encoded (e.g., via a forward error correction (FEC) code) to combat noise and other issues associated with the channel 114. Once encoded, the encoded signals may then be modulated onto a carrier for transmission over the channel 114. The signal waveforms are attenuated, or otherwise altered, by communications channel 114.

FEC is required in terrestrial and satellite systems to provide high quality communication over a radio frequency (RF) propagation channel, which induces signal waveform and spectrum distortions, including signal attenuation (freespace propagation loss), multi-path induced fading and adjacent channel interference. These impairments drive the design of the radio transmission and receiver equipment; exemplary design objectives include selecting modulation formats, error control schemes, demodulation and decoding techniques and hardware components that together provide an efficient balance between system performance and implementation complexity. Differences in propagation channel characteristics, such as between terrestrial and satellite communication channels, naturally result in significantly different system designs. Likewise, existing communications systems continue to evolve in order to satisfy increased system requirements for new higher rate or higher fidelity communication services.

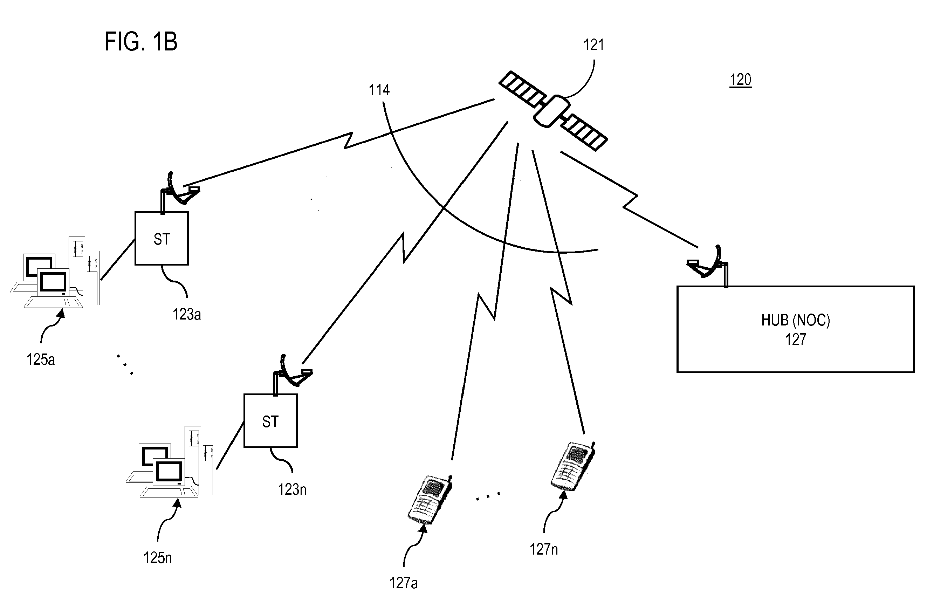

**FIG. 1B** illustrates a satellite communications system capable of employing modulation and coding protocols, in accordance with exemplary embodiments of the present invention. With reference to **FIG. 1B,** satellite communications system 120 includes a satellite 121 that supports communication among multiple satellite terminals (STs) 123a-123n, user terminals (UTs) 127a-127n, and a hub 127. The HUB 127 may assume the role of a Network Operations Center (NOC), which controls the access of the STs 123a-123n and UTs 127a-127n to the system 120, and also provides element management functions and control of the address resolution and resource management functionality. The Satellite communications system 120 may operate as a traditional bent-pipe system, where the satellite essentially operates as a repeater. Alternatively, the system 120 may employ a switching or processing satellite supporting mesh communications (point-to-point communications directly between a pair of the STs 123a-123n and UTs 127a-127n).

In a traditional bent-pipe system of an exemplary embodiment, for example, the satellite operates as a repeater or bent pipe, and communications between the STs 123a-123n and UTs 127a-127n are transmitted over a double-hop path. For example, in a communication from ST 123a to ST 123n, over the first hop, the communication is transmitted, via the satellite, from the ST 123a to the HUB 127. The HUB 127 decodes the communication and determines the destination as ST 123n. The HUB 127 then appropriately addresses and repackages the communication, encodes and modulates it, and transmits the communication over the second hop, via the satellite, to the destination ST 123n. Accordingly, the satellite of such a system acts as a bent pipe or repeater, transmitting communications between the HUB 127 and the STs/UTs.

In an alternate embodiment, with a communications system 120 that employs a processing satellite (e.g., including a packet switch operating, for example, at a data link layer), the system may support direct unicast (point-to-point) communications and multicast communications among the STs 123a-123n and UTs 127a-127n. In the case of a processing satellite, the satellite 121 decodes the received signal and determines the destination ST(s)/UT(s) (as the hub 127 would in a bent-pipe system). The satellite 121 then addresses the data accordingly, encodes and modulates it, and transmits the modulated signal, over the channel 114, to the destination ST(s)/UT(s). Further, the STs 123a-123n may each provide connectivity to one or more respective hosts (e.g., hosts 125a-125n, respectively).

Further, based on recent trends in the advancement of current applications and services and in the development of new applications and services, it is envisioned that systems employing a multiplexing of data signals on the same channel 114 (e.g., time multiplexed), where (on a frame-by-frame basis) such data signals may be destined for different receive terminals of different capabilities (e.g., any combination of STs 125a-125n and UTs 127a-127n. For example, data signals destined for high S/N terminals (e.g., any of the STs 125a-125n) may be multiplexed with data signals destined for lower S/N terminals (e.g., any of the UTs 127a-127n), on the same channel 114 (on a frame-by-frame basis).

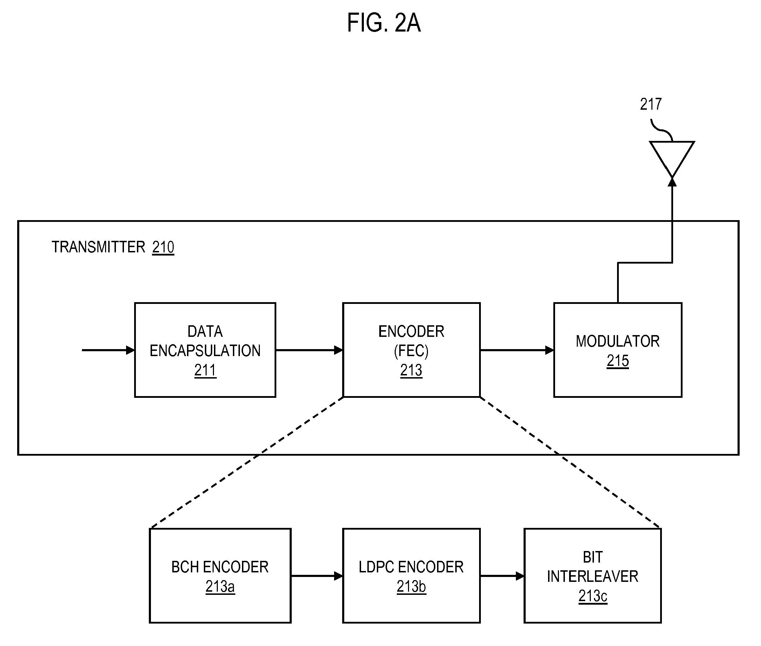

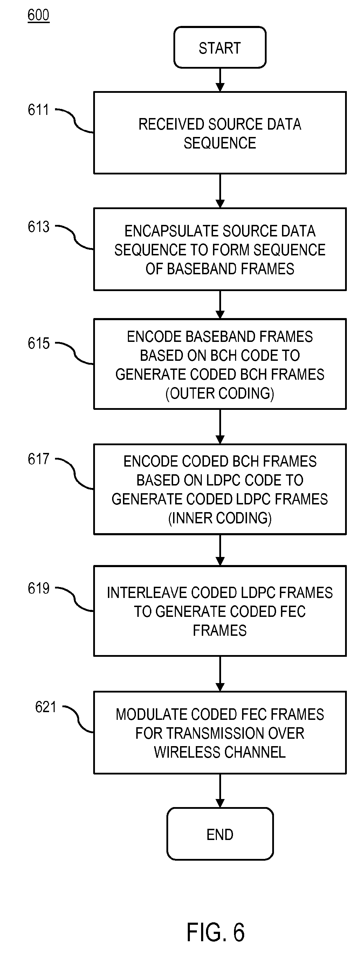

**FIG. 2A** illustrates a block diagram of an exemplary transmitter configured to operate in the systems of **FIGS. 1A and 1B,** in accordance with exemplary embodiments of the present invention. With reference to **FIG. 2A,** the transmitter 210 is equipped with a data encapsulation module 211 that accepts the original application layer source data and performs the upper layer encapsulation to from the baseband frames. The encoder (e.g., an FEC encoder) 213 receives the baseband frames from the data encapsulation module 211, and outputs a coded stream of higher redundancy suitable for error correction processing at the receiver (shown in FIG. 6). The encoded signal is fed to the modulator 215, which maps the encoded messages to signal waveforms, based in part on modulation signal constellations. For example, the data encapsulation module 211 performs the upper layer encapsulation to generate the baseband frames based on the source data bits, and then the encoder 213 and modulator 215 collectively perform the modulation and coding of the baseband frames and the generation of the physical layer frames, in accordance with the exemplary embodiments of the present invention. The physical layer frames are then transmitted (as signal waveforms), via the transmit antenna 217, over the communication channel 114 to the satellite 121.

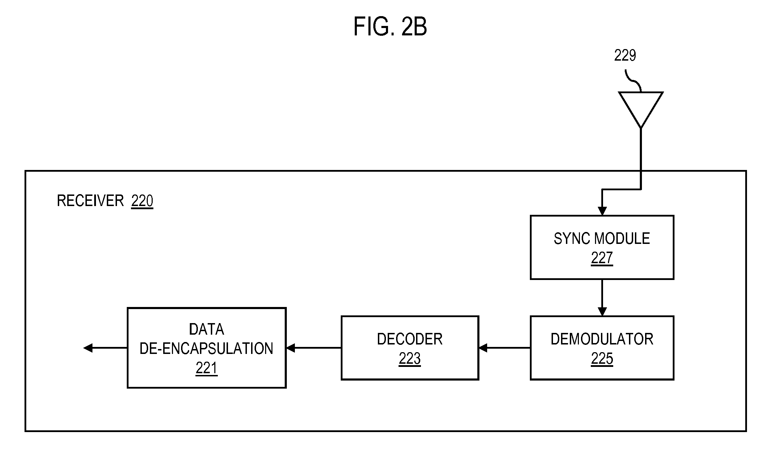

**FIG. 2B** illustrates a block diagram of an exemplary receiver configured to operate in the systems of **FIGS. 1A and 1B,** in accordance with exemplary embodiments of the present invention. With reference to **FIG. 2B,** the receiver 220 comprises receive antenna 229, sync module 227 demodulator 225, decoder 223 and de-encapsulation module 221. The receive antenna 229 receives the signal waveform transmitted over the channel 114 from the satellite 121. The sync module 227 detects the unique word, performs synchronization and determines the modcod and other PLS signaling of the PL Header. The demodulator 225 demodulates the received signal waveforms, based in part on the signal constellation employed for the modulation, to obtain the encoded signals. The decoder 223 then decodes the demodulated bit sequence to generate the encapsulated message data, and the de-encapsulation module 221 de-encapsulates the message data to regenerate the original source data.

As mentioned above, as one exemplary embodiment for broadcast and broadband communications services over satellite networks, the DVB-S2 standard has been adopted globally as a predominant standard for broadcast, interactive and other broadband services and applications. The framing structure, channel coding and modulation systems of the DVB-S2 standard are described in the European Telecommunications Standards Institute (ETSI) publication, ETSI EN 302 307 V1.3.1. DVB-S2 represents a flexible standard, covering a variety of data and multimedia services delivered over satellite communications systems. Generic Stream Encapsulation (GSE) protocols may be employed to provide a data link layer protocol that facilitates the transmission of user or application data from packet oriented protocols (e.g., Internet protocol or IP) on top of a unidirectional physical layer protocol (e.g., DVB-S2). According to the GSE protocol, application data in the form of packet data units (PDUs) are first encapsulated within the baseband frames of the communications network (e.g., DVB-S2 baseband packets in a satellite communications system).

The DVB-S2 standard, for example, was designed to facilitate robust synchronization and signaling at the physical layer, and synchronization and detection of the modulation and coding parameters by a receiver before demodulation and FEC decoding. At the physical layer, baseband frames are encoded to form an output stream of FEC Frames. For example, the baseband frames are encoded by the FEC encoder 213, which comprises a t-error BCH outer coding via the BCH encoder 213a, an LDPC inner coding via the LDPC encoder 213b, and bit interleaving via the bit interleaver 213c. The interleaver 213c reorders the encoded sequence of symbols or bits from the LDPC encoder 213b in a predetermined manner. More specifically, the FEC coding subsystem of DVB-S2 comprises a BCH outer coding, LDPC inner coding and bit interleaving. The input to the FEC subsystem consists of a data stream of baseband frames, where each baseband frame of $K_{bch}$ bits is processed by the coding system to produce an FEC Frame of $n_{ldpc}$ bits, where $n_{ldpc} = 64,800$ for a normal FEC Frame and $n_{ldpc} = 16,200$ for a short FEC Frame.

Physical Layer framing is then performed, by slicing the XFEC Frames into a number of fixed length slots (of length M = 90 symbols each), to generate the physical layer frames, as specified in Section 5.5 of the above-referenced DVB-S2 publication, ETSI EN 302 307.

For the outer BCH coding, the BCH coding parameters are specified in the following tables:

Table 1a: Coding Parameters (normal FEC Frame - LDPC Coded Block $n_{ldpc}$ = 64800)

| LDPC Code Rate | BCH Uncoded Block $K_{bch}$ | BCH Coded Block $N_{bch}$ LDPC Uncoded Block $k_{ldpc}$ | BCH t-Error Correction (bits) |
|---|---|---|---|
| 1/4 | 16008 | 16200 | 12 |
| 1/3 | 21408 | 21600 | 12 |

(continued)

| LDPC Code Rate | BCH Uncoded Block $K_{bch}$ | BCH Coded Block $N_{bch}$ LDPC Uncoded Block $k_{ldpc}$ | BCH t-Error Correction (bits) |
|---|---|---|---|
| 2/5 | 25728 | 25920 | 12 |
| 1/2 | 32208 | 32400 | 12 |
| 3/5 | 36688 | 38880 | 12 |
| 2/3 | 43040 | 43200 | 10 |
| 3/4 | 48408 | 48600 | 12 |
| 4/5 | 51648 | 51840 | 12 |
| 5/6 | 53840 | 54000 | 10 |
| 8/9 | 57472 | 57600 | 8 |
| 9/10 | 58192 | 58320 | 8 |

Table 1b: Coding Parameters (short FEC Frame - LDPC Coded Block $n_{ldpc}$ = 16200)

| LDPC Code Rate | BCH Uncoded Block $K_{bch}$ | BCH Coded Block $N_{bch}$ LDPC Uncoded Block $k_{ldpc}$ | BCH t-Error Correction (bits) | Effective LDPC Rate ($k_{ldpc}$/16200) |
|---|---|---|---|---|
| 1/4 | 3072 | 3240 | 12 | 1/5 |
| 1/3 | 5232 | 5400 | 12 | 1/3 |
| 2/5 | 6312 | 6480 | 12 | 2/5 |
| 1/2 | 7032 | 7200 | 12 | 4/9 |
| 3/5 | 9552 | 9720 | 12 | 3/5 |
| 2/3 | 10632 | 10800 | 12 | 2/3 |
| 3/4 | 11712 | 11880 | 12 | 11/15 |
| 4/5 | 12432 | 12600 | 12 | 7/9 |
| 5/6 | 13152 | 13320 | 12 | 37/45 |
| 8/9 | 14232 | 14400 | 12 | 8/9 |
| 9/10 | N/A | N/A | N/A | N/A |

The generator polynomial of the BCH encoder is obtained by multiplying the first t polynomials specified in the following tables:

Table 2a: BCH Polynomials (normal FEC Frame - LDPC Coded Block $n_{ldpc}$ = 64800)

| $g_1(x)$ | $1+x^2+x^3+x^5+x^{16}$ |
|---|---|
| $g_2(x)$ | $1+x+x^4+x^5+x^6+x^8+x^{16}$ |
| $g_3(x)$ | $1+x^2+x^3+x^4+x^5+x^7+x^8+x^9+x^{10}+x^{11}+x^{16}$ |
| $g_4(x)$ | $1+x^2+x^4+x^6+x^9+x^{11}+x^{12}+x^{14}+x^{16}$ |
| $g_5(x)$ | $1+x+x^2+x^3+x^5+x^8+x^9+x^{10}+x^{11}+x^{12}+x^{16}$ |
| $g_6(x)$ | $1+x^2+x^4+x^5+x^7+x^8+x^9+x^{10}+x^{12}+x^{13}+x^{14}+x^{15}+x^{16}$ |
| $g_7(x)$ | $1+x^2+x^5+x^6+x^8+x^9+x^{10}+x^{11}+x^{13}+x^{15}+x^{16}$ |
| $g_8(x)$ | $1+x+x^2+x^5+x^6+x^8+x^9+x^{12}+x^{13}+x^{14}+x^{16}$ |
| $g_9(x)$ | $1+x^5+x^7+x^9+x^{10}+x^{11}+x^{16}$ |

(continued)

| | |
|---|---|
| $g_{10}(x)$ | $1+x+x^2+x^5+x^7+x^8+x^{10}+x^{12}+x^{13}+x^{14}+x^{16}$ |
| $g_{11}(x)$ | $1+x^2+x^3+x^5+x^9+x^{11}+x^{12}+x^{13}+x^{16}$ |
| $g_{12}(x)$ | $1+x+x^5+x^6+x^7+x^9+x^{11}+x^{12}+x^{16}$ |

Table 2b: BCH Polynomials (short FEC Frame - LDPC Coded Block $n_{ldpc}$ = 16200)

| | |
|---|---|
| $g_1(x)$ | $1+x+x^3+x^5+x^{14}$ |
| $g_2(x)$ | $1+x^6+x^8+x^{11}+x^{14}$ |
| $g_3(x)$ | $1+x+x^2+x^6+x^9+x^{10}+x^{14}$ |
| $g_4(x)$ | $1+x^4+x^7+x^8+x^{10}+x^{12}+x^{14}$ |
| $g_5(x)$ | $1+x^2+x^4+x^6+x^8+x^9+x^{11}+x^{13}+x^{14}$ |
| $g_6(x)$ | $1+x^3+x^7+x^8+x^9+x^{13}+x^{14}$ |
| $g_7(x)$ | $1+x^2+x^5+x^6+x^7+x^{10}+x^{11}+x^{13}+x^{14}$ |
| $g_8(x)$ | $1+x^5+x^8+x^9+x^{10}+x^{11}+x^{14}$ |
| $g_9(x)$ | $1+x+x^2+x^3+x^9+x^{10}+x^{14}$ |
| $g_{10}(x)$ | $1+x^3+x^6+x^9+x^{11}+x^{12}+x^{14}$ |
| $g_{11}(x)$ | $1+x^4+x^{11}+x^{12}+x^{14}$ |
| $g_{12}(x)$ | $1+x+x^2+x^3+x^5+x^6+x^7+x^8+x^{10}+x^{13}+x^{14}$ |

The BCH encoding of information bits $m = (m_{kbch-1}, m_{kbch-2}, \ldots m_1, m_0)$ onto a codeword $c = (m_{kbch-1}, m_{kbch-2}, \ldots m_1, m_0, d_{nbch-kbch-1}, d_{nbch-kbch-2}, \ldots d_1, d_0)$ is achieved as follows: (1) multiply the message polynomial $m(x) = (m_{kbch-1}x^{k_{bch}-1} + m_{kbch-2}x^{k_{bch}-2} + \ldots + m_1x + m_0)$ by $x^{nbch-kbch}$; (2) divide $x^{nbch-kbch}m(x)$ by the generator polynomial $g(x)$, where $d(x) = (d_{nbch-kbch-1}x^{n_{bch}-k_{bch}-1} + \ldots + d_1x + d_0)$ is the remainder; and (3) set the codeword polynomial $c(x) = x^{nbch-kbch}m + d(x)$.

Next, for the LDPC inner coding, the LDPC encoder systematically encodes an information block of size $k_{ldpc}$, $i = (0, i_0, i_1, \ldots, i_{k_{ldpc}-1})$ onto a codeword of size $n_{ldpc}$, $c = (i_0, i_1, \ldots i_{k_{ldpc}-1}, p_0, p_1, \ldots, p_{n_{ldpc}-k_{ldpc}-1})$. The transmission of the codeword starts in the given order from $i_0$ and ends with $p_{n_{ldpc}-k_{ldpc}-1}$. The LDPC code parameters $(k_{ldpc}, n_{ldpc})$ are specified in the above tables 1a and 1b. For backwards compatible modes, the output of the inner code is processed according to Annex F of the above-referenced DVB-S2 publication, ETSI EN 302 307.

The task of the LDPC encoder is to determine $n_{ldpc} - k_{ldpc}$ parity bits $(p_0, p_1, \ldots p_{n_{ldpc}-k_{ldpc}-1})$ for every block of $k_{ldpc}$ information bits $(i_0, i_1, \ldots, i_{k_{ldpc}-1})$. The procedure is as follows: (1) initialize $p_0 = p_1 = \ldots = p_{n_{ldpc}-k_{ldpc}-1} = 0$; (2) for the first information bit $i_0$, accumulate $i_0$ at the parity bit addresses specified in the first row of the table for the respective code rate and FEC Frame size - The tables are specified in Annexes B and C of the above-referenced DVB-S2 publication, ETSI EN 302 307. For example, for the rate 2/3 code for $n_{ldpc}$ = 64800 (Table B.6 of Annex B), where all additions are in GF(2):

$$p_0 = p_0 \oplus i_0 \qquad\qquad p_{2767} = p_{2767} \oplus i_0$$

$$p_{10491} = p_{10491} \oplus i_0 \qquad\qquad p_{240} = p_{240} \oplus i_0$$

$$p_{16043} = p_{16043} \oplus i_0 \qquad\qquad p_{18673} = p_{18673} \oplus i_0$$

$$p_{506} = p_{506} \oplus i_0 \qquad\qquad p_{9279} = p_{9279} \oplus i_0$$

$$p_{12826} = p_{12826} \oplus i_0 \qquad\qquad p_{10579} = p_{10579} \oplus i_0$$

$$p_{8065} = p_{8065} \oplus i_0 \qquad\qquad p_{20928} = p_{20928} \oplus i_0$$

$$p_{8226} = p_{8226} \oplus i_0$$

(3) for the next 359 information bits $i_m$, $m$ = 1,2,..., 359, accumulate $i_m$ at parity bit addresses $\{x + m$ mod 360 * $q\}$ $mod$ $(n_{ldpc} - k_{ldpc})$, where $x$ denotes the address of the parity bit accumulator corresponding to the first bit $i_0$, and $q$ is a code rate dependent constant (specified in Tables 3a and 3b, below). Continuing with the example for the rate 2/3 code for $n_{ldpc}$ = 64800, $q$ = 60 - so, for example, for information bit $i_1$, the following operations are performed:

$$p_{60} = p_{60} \oplus i_1 \qquad\qquad p_{2827} = p_{2827} \oplus i_1$$

$$p_{10551} = p_{10551} \oplus i_1 \qquad\qquad p_{300} = p_{300} \oplus i_1$$

$$p_{16103} = p_{16103} \oplus i_1 \qquad\qquad p_{18733} = p_{18733} \oplus i_1$$

$$p_{566} = p_{566} \oplus i_1 \qquad\qquad p_{9339} = p_{9339} \oplus i_1$$

$$p_{12886} = p_{12886} \oplus i_1 \qquad\qquad p_{10639} = p_{10639} \oplus i_1$$

$$p_{8125} = p_{8125} \oplus i_1 \qquad\qquad p_{20988} = p_{20988} \oplus i_1$$

$$p_{8286} = p_{8286} \oplus i_1$$

(4) for the 361st information bit $i_{360}$, accumulate $i_{360}$ at the parity bit addresses specified in the second row of the appropriate table (in Annexes B and C of ETSI EN 302 307) table for the respective code rate and FEC Frame size. Then, in a similar manner the addresses of the parity bit accumulators for the following 359 information bits $i_m$, $m$ = 361, 362, ..., 719 are obtained using the formula $\{x + m$ mod 360 * $q\}$ $mod$ $(n_{ldpc} - k_{ldpc})$, where $x$ denotes the address of the parity bit accumulator corresponding to the first bit $i_{360}$, (the entries of the second row of the respective table); and (5) in a similar manner, for every group of 360 new information bits, a new row from the respective table is used to find the addresses of the parity bit accumulators.

Then, once all the information bits are exhausted, the final parity bits are obtained by sequentially performing the following operations, starting with $i$ =1, $p_i = p_i \oplus p_{i-1}$, where $i$ = 1, 2,..., $n_{ldpc} - k_{ldpc}$ - 1 , and then the final content of $p_i$, $i$ = 0,1,..., $n_{ldpc} - k_{ldpc}$ - 1 is equal to the parity bit $p_i$.

Table 3a: $q$ Values (normal FEC Frame - LDPC Coded Block $n_{ldpc}$ = 64800)

| LDPC Code Rate | $q$ |
|---|---|
| 1/4 | 135 |
| 1/3 | 120 |
| 2/5 | 108 |
| 1/2 | 90 |
| 3/5 | 72 |

(continued)

| LDPC Code Rate | $q$ |
|---|---|
| 2/3 | 60 |
| 3/4 | 45 |
| 4/5 | 36 |
| 5/6 | 30 |
| 8/9 | 20 |
| 9/10 | 18 |

Table 3b: $q$ Values (short FEC Frame - LDPC Coded Block $n_{ldpc}$ = 16200)

| LDPC Code Rate | $q$ |
|---|---|
| 1/4 | 36 |
| 1/3 | 30 |
| 2/5 | 27 |
| 1/2 | 25 |
| 3/5 | 18 |
| 2/3 | 15 |
| 3/4 | 12 |
| 4/5 | 10 |
| 5/6 | 8 |
| 8/9 | 5 |

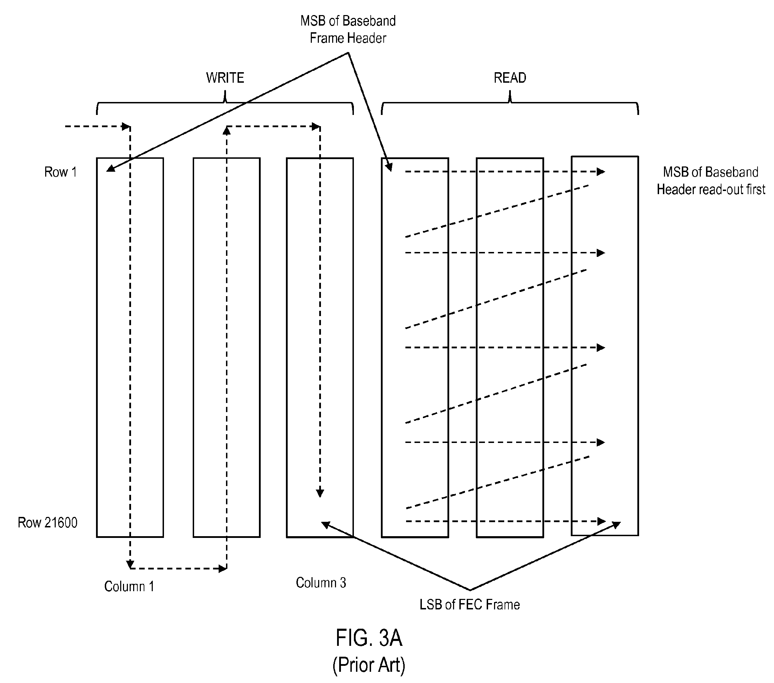

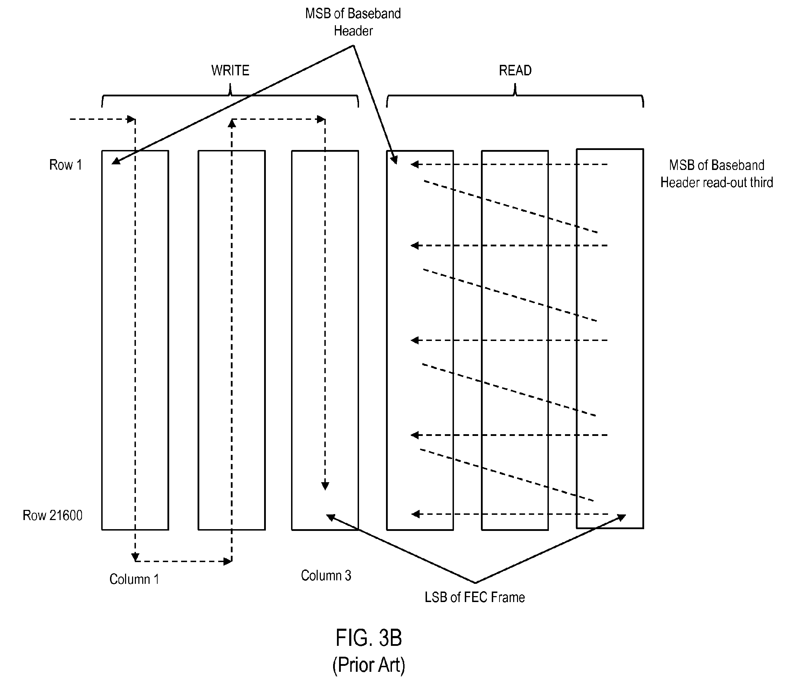

With reference to **FIGS. 3A and 3B,** for the 8PSK, 16APSK and 32APSK modulation schemes of the DVB-S2 standard, the bit interleaver 213c comprises a block interleaver that interleaves the output of the LDPC encoder 213b. Data is serially written into the interleaver column-wise, and serially read out row-wise (the MSB of baseband frame header is read out first, except in the case of the 8PSK rate 3/5 modulation where MSB of the baseband frame header is read out third), as illustrated in **FIGS. 3A and 3B,** respectively. The configuration of the block interleaver for each modulation format is specified in the following table:

Table 4: Block Interleaver Configurations

| Modulation | Rows ($n_{ldpc}$ = 64800) | Rows ($n_{ldpc}$ = 16200) | Columns |
|---|---|---|---|
| 8PSK | 21600 | 5400 | 3 |
| 16APSK | 16200 | 4050 | 4 |
| 32APSK | 12960 | 3240 | 5 |

For the DVB-S2 modulation, each FEC Frame (comprising a sequence of 64,800 bits for a normal FEC Frame, or 16,200 bits for a short FEC Frame) is then modulated based on one of various options specified in the standard for modulation of the data payload (e.g., QPSK, 8PSK, 16APSK, or 32APSK). For example, each FEC Frame is serial-to-parallel converted with the following parallelism levels: $\eta_{MOD}$ 2 for QPSK; $\eta_{MOD}$ 3 for 8PSK; $\eta_{MOD}$ 4 for 16APSK; $\eta_{MOD}$ 5 for 32APSK. Then, each resulting parallel sequence is mapped based on a signal constellation, generating an (I, Q) sequence of variable length depending on the selected modulation efficiency ($\eta_{MOD}$ bits/Hz). The DVB-S2 signal constellations for the QPSK, 8PSK, 16APSK, and 32 APSK modulation schemes are illustrated in Figures 9-12 (respectively) of the above-referenced DVB-S2 publication, ETSI EN 302 307. The resulting output sequence is referred to as a complex FEC Frame or XFEC Frame, composed of $64,800/\eta_{MOD}$(normal XFEC Frame) modulation symbols, or $16,200/\eta_{MOD}$(short XFEC Frame) modulation symbols. Each modulation symbol thereby comprises a complex vector in the format (I, Q) (I being the in-phase component and Q the quadrature component), or in the equivalent format $\rho \exp j\emptyset$ ($\rho$ being the modulus of the vector and 0 being its phase).

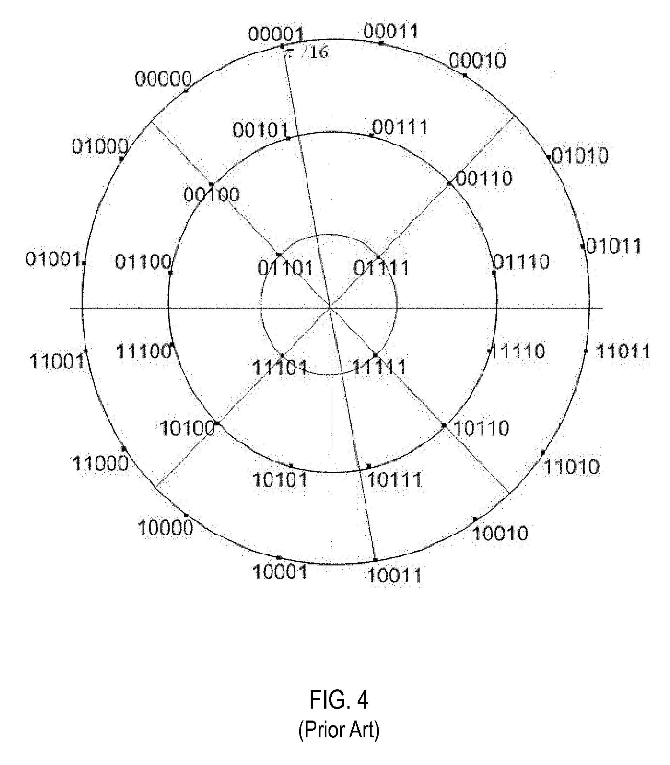

With respect to other current modulation schemes, U.S. patent application numbers 13/327,316 and 13/890,643 provide a 32APSK constellation. The 32APSK signal constellation is provided with a ring format of 4+12+16 (4 constellation points on the inner-most ring, 12 constellation points on the next outer ring, and 16 constellation points on the outer-most ring). The bit labeling and [x, y] signal point coordinates (where the outer ring is rotated by $\pi$/16 as compared to the DVB-S2 32APSK constellation) of this 32APSK constellation are as follows (where $\varepsilon_x$ represents average energy per symbol, 4 * R1$^2$ + 12 * R2$^2$ + 16 * R3$^2$ = 32, and R1 represents the radius of the inner-most ring, R2 represents the radius of the middle ring and R3 represents the radius of the outer ring), as further illustrated in FIG. 4:

| Bit Label | [x, y] Coordinates |
|---|---|
| **00000** | $[-R3 * \sqrt{\varepsilon_x} * \cos(5.0 * \pi/16.0), R3 * \sqrt{\varepsilon_x} * \cos(3.0 * \pi/16.0)]$ |
| 00001 | $[-R3 * \sqrt{\varepsilon_x} * \cos(7.0 * \pi/16.0), R3 * \sqrt{\varepsilon_x} * \cos(\pi/16.0)]$ |
| 00010 | $[R3 * \sqrt{\varepsilon_x} * \cos(5.0 * \pi/16.0), R3 * \sqrt{\varepsilon_x} * \cos(3.0 * \pi/16.0)]$ |
| 00011 | $[R3 * \sqrt{\varepsilon_x} * \cos(7.0 * \pi/16.0), R3 * \sqrt{\varepsilon_x} * \cos(\pi/16.0)]$ |
| 00100 | $[-R2 * \sqrt{\varepsilon_x} * \sin(\pi/4.0), R2 * \sqrt{\varepsilon_x} * \sin(\pi/4.0)]$ |
| 00101 | $[-R2 * \sqrt{\varepsilon_x} * \sin(\pi/12.0), R2 * \sqrt{\varepsilon_x} * \sin(5.0 * \pi/12.0)]$ |
| 00110 | $[R2 * \sqrt{\varepsilon_x} * \sin(\pi/4.0), R2 * \sqrt{\varepsilon_x} * \sin(\pi/4.0)]$ |
| 00111 | $[R2 * \sqrt{\varepsilon_x} * \sin(\pi/12.0), R2 * \sqrt{\varepsilon_x} * \sin(5.0 * \pi/12.0)]$ |
| 01000 | $[-R3 * \sqrt{\varepsilon_x} * \cos(3.0 * \pi/16.0), R3 * \sqrt{\varepsilon_x} * \cos(5.0 * \pi/16.0)]$ |
| 01001 | $[-R3 * \sqrt{\varepsilon_x} * \cos(\pi/16.0), R3 * \sqrt{\varepsilon_x} * \cos(7.0 * \pi/16.0)]$ |
| 01010 | $[R3 * \sqrt{\varepsilon_x} * \cos(3.0 * \pi/16.0), R3 * \sqrt{\varepsilon_x} * \cos(5.0 * \pi/16.0)]$ |
| 01011 | $[R3 * \sqrt{\varepsilon_x} * \cos(\pi/16.0), R3 * \sqrt{\varepsilon_x} * \cos(7.0 * \pi/16.0)]$ |
| 01100 | $[-R2 * \sqrt{\varepsilon_x} * \sin(5.0 * \pi/12.0), R2 * \sqrt{\varepsilon_x} * \sin(\pi/12.0)]$ |
| 01101 | $[-R1 * \sqrt{\varepsilon_x} * \sin(\pi/4.0), R1 * \sqrt{\varepsilon_x} * \sin(\pi/4.0)]$ |
| 01110 | $[R2 * \sqrt{\varepsilon_x} * \sin(5.0 * \pi/12.0), R2 * \sqrt{\varepsilon_x} * \sin(\pi/12.0)]$ |
| 01111 | $[R1 * \sqrt{\varepsilon_x} * \sin(\pi/4.0), R1 * \sqrt{\varepsilon_x} * \sin(\pi/4.0)]$ |
| 10000 | $[-R3 * \sqrt{\varepsilon_x} * \cos(5.0 * \pi/16.0), -R3 * \sqrt{\varepsilon_x} * \cos(3.0 * \pi/16.0)]$ |
| 10001 | $[-R3 * \sqrt{\varepsilon_x} * \cos(7.0 * \pi/16.0), -R3 * \sqrt{\varepsilon_x} * \cos(\pi/16.0)]$ |
| 10010 | $[R3 * \sqrt{\varepsilon_x} * \cos(5.0 * \pi/16.0), -R3 * \sqrt{\varepsilon_x} * \cos(3.0 * \pi/16.0)]$ |

(continued)

| Bit Label | [x, y] Coordinates |
|---|---|
| 10011 | $[R3 * \sqrt{\varepsilon_x} * \cos(7.0 * \pi/16.0), -R3 * \sqrt{\varepsilon_x} * \cos(\pi/16.0)]$ |
| 10100 | $[-R2 * \sqrt{\varepsilon_x} * \sin(\pi/4.0), -R2 * \sqrt{\varepsilon_x} * \sin(\pi/4.0)]$ |
| 10101 | $[-R2 * \sqrt{\varepsilon_x} * \sin(\pi/12.0), -R2 * \sqrt{\varepsilon_x} * \sin(5.0 * \pi/12.0)]$ |
| 10110 | $[R2 * \sqrt{\varepsilon_x} * \sin(\pi/4.0), -R2 * \sqrt{\varepsilon_x} * \sin(\pi/4.0)]$ |
| 10111 | $[R2 * \sqrt{\varepsilon_x} * \sin(\pi/12.0), -R2 * \sqrt{\varepsilon_x} * \sin(5.0 * \pi/12.0)]$ |
| 11000 | $[-R3 * \sqrt{\varepsilon_x} * \cos(3.0 * \pi/16.0), -R3 * \sqrt{\varepsilon_x} * \cos(5.0 * \pi/16.0)]$ |
| 11001 | $[-R3 * \sqrt{\varepsilon_x} * \cos(\pi/16.0), -R3 * \sqrt{\varepsilon_x} * \cos(7.0 * \pi/16.0)]$ |
| 11010 | $[R3 * \sqrt{\varepsilon_x} * \cos(3.0 * \pi/16.0), -R3 * \sqrt{\varepsilon_x} * \cos(5.0 * \pi/16.0)]$ |
| 11011 | $[R3 * \sqrt{\varepsilon_x} * \cos(\pi/16.0), -R3 * \sqrt{\varepsilon_x} * \cos(7.0 * \pi/16.0)]$ |
| 11100 | $[-R2 * \sqrt{\varepsilon_x} * \sin(5.0 * \pi/12.0), -R2 * \sqrt{\varepsilon_x} * \sin(\pi/12.0)]$ |
| 11101 | $[-R1 * \sqrt{\varepsilon_x} * \sin(\pi/4.0), -R1 * \sqrt{\varepsilon_x} * \sin(\pi/4.0)]$ |
| 11110 | $[R2 * \sqrt{\varepsilon_x} * \sin(5.0 * \pi/12.0), -R2 * \sqrt{\varepsilon_x} * \sin(\pi/12.0)]$ |
| 11111 | $[R1 * \sqrt{\varepsilon_x} * \sin(\pi/4.0), -R1 * \sqrt{\varepsilon_x} * \sin(\pi/4.0)]$ |

This 32APSK constellation achieves improved performance over other current 32APSK modulation constellations (e.g., approximately 0.2 dB better performance over the 32APSK constellation of the DVB-S2 standard). Despite the better performance of this constellation, however, to maintain compatibility with the DVB-S2 standard (and preserve the 32APSK modcods thereof), the 32APSK constellation may be applied with only those new codes (and respective code rates), provided pursuant to the exemplary embodiments of the present invention, disclosed herein. As is evident, though, this 32APSK constellation could be applied with other codes (and respective code rates), such as those provided in the DVB-S2 standard.

As specified above, however, current modulation and coding schemes (e.g., the modulation and coding schemes of the DVB-S2 standard) lack support for the operational requirements of terminals at relatively low $E_s/N_0$ ratios (e.g., below approximately -3 dB). Additionally, such current modulation and coding schemes also lack sufficient granularity for terminals within an intermediate $E_s/N_0$ operational range (e.g., from approximately -3 dB to 15.5 dB). Moreover, codes of shorter block sizes are also needed within such operational ranges.

In accordance with exemplary embodiments of the present invention, therefore, modulation and coding schemes are provided that support terminals with operational requirements at relatively low $E_s/N_0$ ratios (e.g., within the range of approximately -3 dB to -10 dB), and that provide finer granularity for terminals with operational requirements within an intermediate operational range (e.g., approximately -3 dB to 15.5 dB). Further, such new modulation and coding schemes are provided with intermediate block lengths. For example, exemplary embodiments provide the following new improved modulation and coding schemes:

Table 5: Modulation and Code Rates

| Modulation | Code Rate |
|---|---|
| $\pi/2$ BPSK | 1/5 |
| $\pi/2$ BPSK | 11/45 |
| $\pi/2$ BPSK | 1/3 |
| QPSK | 1/5 |
| QPSK | 11/45 |
| QPSK | 1/3 |

Additionally, with respect to the outer BCH coding of the FEC encoding, in accordance with exemplary embodiments, the coding is performed as described above based on the coding parameters (including the BCH t-error correction parameters) and the BCH polynomials as specified in the following tables 6a and 6b:

Table 6a: Coding Parameters (medium FERFRAME $n_{ldpc}$ = 32400)

| LDPC Code Identifier | BCH uncoded block $K_{BCH}$ | BCH coded block $N_{BCH}$ LDPC uncoded block $k_{ldpc}$ | BCH t-error correction | LDPC coded block $n_{ldpc}$ |
|---|---|---|---|---|
| 1/5 | 6300 | 6480 | 12 | 32400 |
| 11/45 | 7740 | 7920 | 12 | 32400 |
| 1/3 | 10620 | 10800 | 12 | 32400 |

Table 6b: BCH Polynomials (medium FECFRAME $n_{ldpc}$ = 32400)

| $g_1(x)$ | $1+x^2+x^3+x^5+x^{15}$ |
|---|---|
| $g_2(x)$ | $1+x+x^4+x^7+x^{10}+x^{11}+x^{15}$ |
| $g_3(x)$ | $1+x^2+x^4+x^6+x^8+x^{10}+x^{12}+x^{13}+x^{15}$ |
| $g_4(x)$ | $1+x^2+x^3+x^5+x^6+x^8+x^{10}+x^{11}+x^{15}$ |
| $g_5(x)$ | $1+x+x^2+x^4+x^6+x^7+x^{10}+x^{12}+x^{15}$ |
| $g_6(x)$ | $1+x^4+x^6+x^7+x^{12}+x^{13}+x^{15}$ |
| $g_7(x)$ | $1+x^2+x^4+x^5+x^7+x^{11}+x^{12}+x^{14}+x^{15}$ |
| $g_8(x)$ | $1+x^2+x^4+x^6+x^8+x^9+x^{11}+x^{14}+x^{15}$ |
| $g_9(x)$ | $1+x+x^2+x^4+x^5+x^7+x^9+x^{11}+x^{12}+x^{13}+x^{15}$ |
| $g_{10}(x)$ | $1+x+x^2+x^3+x^4+x^7+x^{10}+x^{11}+x^{12}+x^{13}+x^{15}$ |
| $g_{11}(x)$ | $1+x+x^2+x^4+x^9+x^{11}+x^{15}$ |
| $g_{12}(x)$ | $1+x^2+x^4+x^8+x^{10}+x^{11}+x^{13}+x^{14}+x^{15}$ |

Further, with respect to bit interleaving, because such exemplary embodiments do not apply the provided intermediate codes with high-order modulation schemes, interleaving is not generally employed. The scope of potential embodiments of the present invention, however, would not preclude the application of an interleaver, or the application of the provided intermediate codes with high-order modulation scenarios.

With respect to the inner LDPC coding of the FEC encoding, in accordance with exemplary embodiments of the present invention, the respective parity bit accumulator address tables for the respective code rates and FEC Frame lengths are specified in the following parity bit accumulator tables (where, for each code rate $R$, the $q$ values are as follows: $q = (n - k)/360$, (where $n = 32400$ and $k = R * n$)):

Table 8: $q$ Values

| Code Rate | $q$ |
|---|---|
| 1/5 | 72 |
| 11/45 | 68 |
| 1/3 | 60 |

| Table 9a: Address of Parity Bit Accumulators (Rate 1/5) ($n_{ldpc}$=32400) |
|---|
| 18222 6715 4908 21568 22821 11708 4769 4495 22243 25872 9051 19072 13956 |
| 2038 5205 21215 21009 9584 2403 23652 20866 20130 677 9509 6136 773 |
| 19936 14590 17829 473 4432 23171 11386 17937 22084 24450 267 8822 19335 |
| 16376 16769 5111 9794 18907 827 12385 12370 21647 10938 23619 11633 15865 |
| 23417 7631 12243 21546 4192 22117 14757 4118 9686 17021 8531 15989 8807 |
| 15533 16584 18529 19699 17821 4252 1254 5952 3163 20295 6944 1022 19743 |
| 129 16579 23524 25897 14690 11222 16250 9925 4268 999 7102 24528 152 |
| 18361 3708 3454 16604 1551 5809 20324 4775 22418 19091 19674 10975 7327 |
| 24133 10950 22779 11388 13818 20668 7556 12333 16446 19684 12510 25118 8162 |
| 17026 6850 1269 |
| 21895 7137 25270 |
| 11858 24153 13303 |
| 7885 16438 12805 |
| 10473 15004 8052 |
| 2088 10379 10067 |
| 21438 13426 10440 |
| 17696 727 12164 |
| 22623 8408 17849 |

| Table 9b: Address of Parity Bit Accumulators (Rate 11/45) ($n_{ldpc}$=32400) |
|---|
| 20617 6867 14845 11974 22563 190 17207 4052 7406 16007 |
| 21448 14846 2543 23380 16633 20365 16869 13411 19853 795 |
| 5200 2330 2775 23620 20643 10745 14742 6493 14222 20939 |
| 9445 9523 12769 7332 21792 18717 16397 14016 9481 22162 |
| 2922 6427 4497 4116 17658 2581 14364 3781 18851 22974 |
| 10383 2184 1433 3889 12828 17424 17580 20936 1390 21374 |
| 425 2063 22398 20907 9445 14790 4457 723 7048 4072 |
| 11771 9640 23212 9613 12042 8335 21386 20129 13521 16301 |
| 14867 12501 1086 21526 17701 17731 20907 8790 19224 5784 |
| 7107 19690 17616 5800 9501 23320 16878 794 15931 17539 |
| 4556 21783 1524 |
| 20100 11706 23663 |
| 2535 15530 6116 |
| 12078 3867 2663 |
| 19629 20246 7024 |
| 11748 11426 19802 |
| 15942 12333 5316 |
| 11521 3170 17818 |
| 2289 23780 16575 |
| 6649 16991 13025 |
| 20050 10619 10250 |

(continued)

| Table 9b: Address of Parity Bit Accumulators (Rate 11/45) ($n_{ldpc}$=32400) |
|---|
| 3944 13063 5656 |

| Table 9c: Address of Parity Bit Accumulators (Rate 1/3) ($n_{ldpc}$=32400) |
|---|
| 7416 4093 16722 1023 20586 12219 9175 16284 1554 10113 19849 17545 |
| 13140 3257 2110 13888 3023 1537 1598 15018 18931 13905 10617 1014 |
| 339 14366 3309 15360 18358 3196 4412 6023 7070 17380 2777 6691 |
| 12720 17634 4141 1400 8247 18201 16077 11314 11928 3494 3155 2865 |
| 21038 6928 3860 1943 20292 6526 12939 15182 3957 5651 356 2673 |
| 20555 17905 5724 13932 1218 17763 5912 5164 6233 6220 1277 19209 |
| 19190 4498 4950 6645 5482 5667 13701 16334 15231 735 8589 12344 |
| 679 17849 17807 16033 10181 3368 5778 8275 2736 14042 17506 6005 |
| 1576 10259 10525 3007 16522 697 7726 8641 14323 2893 8168 11070 |
| 17270 10180 18740 847 4969 14715 19316 5530 17428 11193 9861 13562 |
| 6156 18787 10467 |
| 2422 3723 10769 |
| 8015 18716 13406 |
| 5969 15949 3084 |
| 6855 13990 3764 |
| 10351 15779 10392 |
| 16078 19034 11279 |
| 11747 6608 4188 |
| 19699 8928 8045 |
| 4598 7219 11391 |
| 19766 11871 5692 |
| 7487 15905 17621 |
| 8554 7751 16516 |
| 4981 20250 16146 |
| 12524 21364 10793 |
| 17083 2051 8862 |
| 1315 6246 7721 |
| 18043 16652 5502 |
| 1432 5674 2224 |
| 11257 1312 8453 |

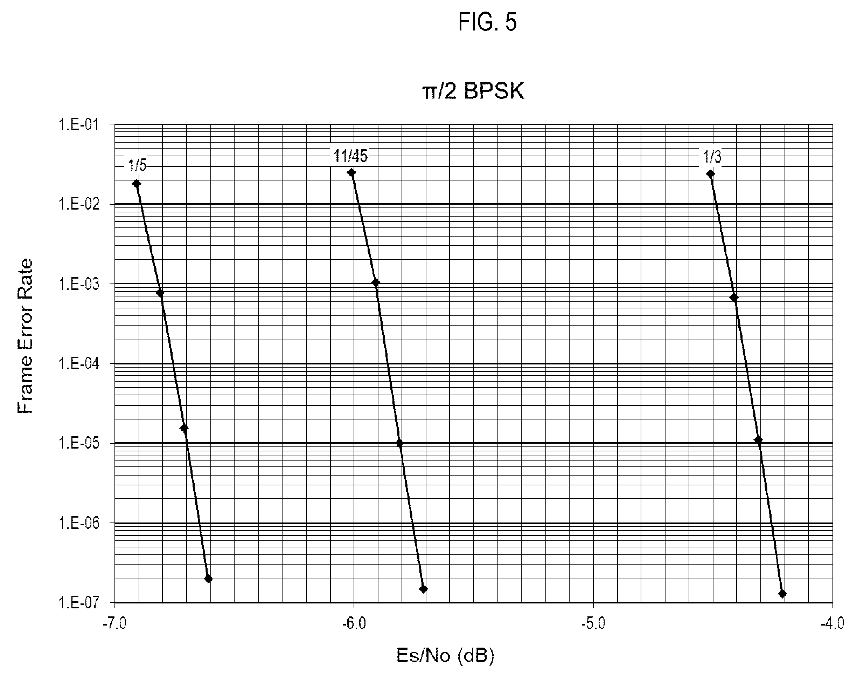

FIG. 5 illustrates simulated performance curves for the provided modulation and coding schemes (listed above in Table 5) over an AWGN channel, in accordance with exemplary embodiments of the present invention.

FIG. 6 illustrates a flow chart of the encoding and modulation processes described above, in accordance with exemplary embodiments of the present invention. For example, the encoding and modulation process 600 may be performed by a transmitter 210 as depicted in FIG. 2A. With reference to FIG. 6, the process starts at step 611, where a source data sequence is received, for example, by the data encapsulation module 211. At step 613, the encapsulation module encapsulates the source data sequence to form a sequence of baseband frames. At step 615, the BCH encoder 213a encodes the baseband frames in accordance with a t-error BCH code to generate respective coded BCH data frames. At step 617, the LDPC encoder 213b encodes the coded BCH data frames in accordance with a structured LDPC code to generate coded LDPC data frames. At step 619 (if interleaving is applied), the bit interleaver 213c interleaves the coded bits of the coded LDPC data frames to generate coded FEC frames. At step 621 the modulator 215 modulates the coded FEC frames in accordance with a selected modulation scheme for transmission over the wireless satellite channel 114.

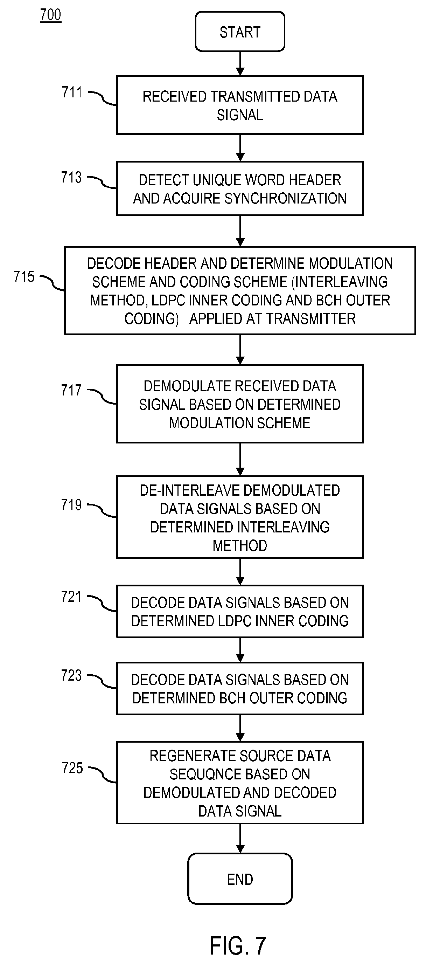

FIG. 7 illustrates a flow chart of an exemplary process for demodulating and decoding a received data signal transmission to replicate a source data sequence of information bits that was encoded and modulated as described above, in accordance with exemplary embodiments of the present invention. For example, the decoding and demodulation process 700 may be performed by a receiver 220 as depicted in **FIG. 2B.** With reference to **FIG. 7,** the process starts at step 711, where the data signals transmitted over the satellite channel 114 are received by the receiver 220. At step 713, the sync module 227 detects the unique word and acquires synchronization. At step 715, the receiver decodes header information to determine the modulation scheme and coding scheme (e.g., the interleaving method - if applied, LDPC inner coding and BCH outer coding applied at the transmitter). The decoding of the header information, for example, may be performed by the sync module 227 or the decoder module 223 (or by another module of the receiver configured to perform such header decoding - not shown in FIG. 2B). At step 717, the demodulator 225 demodulates the received data signals based on the determined modulation scheme to generate a received replica of the transmitted FEC frames. At step 719 (if interleaving was applied in the encoding), the decoder 223 de-interleaves the demodulated data frames based on the determined interleaving method. At step 721, the decoder 723 decodes the de-interleaved data based on the determined LDPC inner coding. At step 723, the decoder 223 further decodes the data frames based on the determined BCH outer coding. Then at step 725, the data de-encapsulation module de-encapsulates the decoded data frames to generate a replica of the original source data sequence.

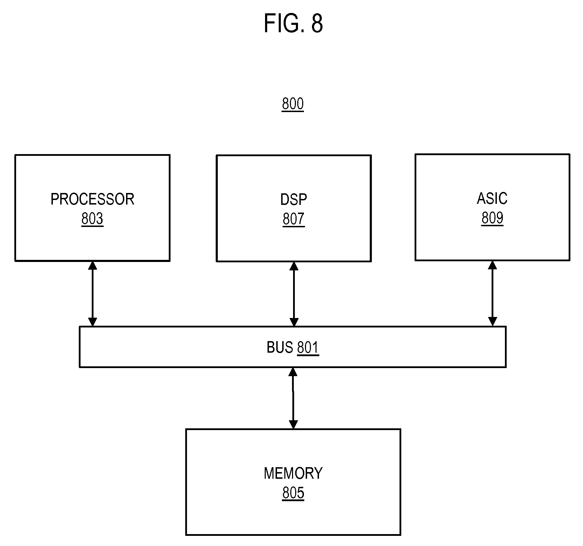

**FIG. 8** illustrates a block diagram of a chip set that can be utilized in implementing communications system protocols, according to exemplary embodiments of the present invention. With reference to **FIG. 8,** chip set 800 includes, for instance, processor and memory components described with respect to FIG. 5 incorporated in one or more physical packages. By way of example, a physical package includes an arrangement of one or more materials, components, and/or wires on a structural assembly (e.g., a baseboard) to provide one or more characteristics such as physical strength, conservation of size, and/or limitation of electrical interaction.

In one embodiment, the chip set 800 includes a communication mechanism such as a bus 801 for passing information among the components of the chip set. A processor 803 has connectivity to the bus 801 to execute instructions and process information stored in, for example, a memory 805. The processor 803 includes one or more processing cores with each core configured to perform independently. A multi-core processor enables multiprocessing within a single physical package. Examples of a multi-core processor include two, four, eight, or greater numbers of processing cores. Alternatively or in addition, the processor 503 includes one or more microprocessors configured in tandem via the bus 801 to enable independent execution of instructions, pipelining, and multithreading. The processor 803 may also be accompanied with one or more specialized components to perform certain processing functions and tasks such as one or more digital signal processors (DSP) 807, and/or one or more application-specific integrated circuits (ASIC) 809. A DSP 807 typically is configured to process real-world signals (e.g., sound) in real time independently of the processor 803. Similarly, an ASIC 809 can be configured to performed specialized functions not easily performed by a general purposed processor. Other specialized components to aid in performing the inventive functions described herein include one or more field programmable gate arrays (FPGA) (not shown), one or more controllers (not shown), or one or more other special-purpose computer chips.

The processor 803 and accompanying components have connectivity to the memory 805 via the bus 801. The memory 805 may comprise various forms of computer-readable media, e.g., including both dynamic memory (e.g., RAM) and static memory (e.g., ROM) for storing executable instructions that, when executed by the processor 803 and/or the DSP 807 and/or the ASIC 809, perform the process of exemplary embodiments as described herein. The memory 805 also stores the data associated with or generated by the execution of the process.

The term "computer-readable medium" or "computer-readable media," as used herein, refers to any medium that participates in providing instructions for execution by the processor 803, and/or one or more of the specialized components, such as the one or more digital signal processors (DSP) 807, and/or one or more application-specific integrated circuits (ASIC) 809. Such a medium may take many forms, including but not limited to non-volatile media, volatile media, and transmission media. Non-volatile media include, for example, read only memory (ROM), included within memory 805. Volatile media, for example, may include dynamic random access memory (RAM), included within memory 805. Transmission media may include copper or other conductive wiring, fiber optics, or other physical transmission media, including the wires and/or optical fiber that comprise bus 801. Transmission media can also take the form of wireless data signals, such as those generated during radio frequency (RF) and infrared (IR) data communications. Common forms of computer-readable media include, for example, magnetic storage media (e.g., magnetic hard disks or any other magnetic storage medium), solid state or semiconductor storage media (e.g., RAM, PROM, EPROM, FLASH EPROM, a data storage device that uses integrated circuit assemblies as memory to store data persistently, or any other storage memory chip or module), optical storage media (e.g., CD ROM, CDRW, DVD, or any other optical storage medium), a or any other medium for storing data from which a computer or processor can read.

Various forms of computer-readable media may be involved in providing instructions to a processor for execution. For example, the instructions for carrying out at least part of the present invention may initially be borne on a magnetic disk of a remote computer. In such a scenario, the remote computer loads the instructions into main memory and sends the instructions over a telephone line using a modem. A modem of a local computer system receives the data on the telephone line and uses an infrared transmitter to convert the data to an infrared signal and transmit the infrared signal to a portable computing device, such as a personal digital assistance (PDA) and a laptop. An infrared detector on the portable computing device receives the information and instructions borne by the infrared signal and places the data on a bus. The bus conveys the data to main memory, from which a processor retrieves and executes the instructions. The instructions received by main memory may optionally be stored on storage device either before or after execution by processor.

Moreover, as will be appreciated, a module or component (as referred to herein) may be composed of software component(s), which are stored in a memory or other computer-readable storage medium, and executed by one or more processors or CPUs of the respective devices. As will also be appreciated, however, a module may alternatively be composed of hardware component(s) or firmware component(s), or a combination of hardware, firmware and/or software components. Further, with respect to the various exemplary embodiments described herein, while certain of the functions are described as being performed by certain components or modules (or combinations thereof), such descriptions are provided as examples and are thus not intended to be limiting.

While exemplary embodiments of the present invention may provide for various implementations (e.g., including hardware, firmware and/or software components), and, unless stated otherwise, all functions are performed by a CPU or a processor executing computer executable program code stored in a non-transitory memory or computer-readable storage medium, the various components can be implemented in different configurations of hardware, firmware, software, and/or a combination thereof. Except as otherwise disclosed herein, the various components shown in outline or in block form in the figures are individually well known and their internal construction and operation are not critical either to the making or using of this invention or to a description of the best mode thereof.

In the preceding specification, various embodiments have been described with reference to the accompanying drawings. It will, however, be evident that various modifications may be made thereto, and additional embodiments may be implemented, without departing from the broader scope of the invention as set forth in the claims that follow. The specification and drawings are accordingly to be regarded in an illustrative rather than restrictive sense.

## Claims

1. A method for encoding comprising:

    encoding, by a processor of a device, a source data sequence of information bits based on a predetermined structured parity check matrix of an LDPC code, where LDPC is Low Density Parity Check, wherein the encoding is performed based on frames of the source data sequence, each frame being of a length of $k_{ldpc}$ information bits $i_0, i_1,..., i_{k_{ldpc}-1}$, and the output of the encoding comprises coded LDPC frames each being $n_{ldpc}$ coded bits in length, wherein $n_{ldpc}$ = 32400 and

    wherein the structured parity check matrix is represented by tabular information of a format wherein each row represents occurrences of one values within a respective column of the parity check matrix, and the columns of the parity check matrix are derived according to a predetermined operation based on the respective rows of the tabular information, and wherein the tabular information comprises a one of Tables **1a** through **1c;**

    wherein the encoding comprises generating $n_{ldpc}$ - $k_{ldpc}$ parity bits $p_0, p_1,..., p_{n_{ldpc}-k_{ldpc}-1}$ for each frame of the source data sequence, wherein the generation of the parity bits comprises:

       initializing parity bit accumulators for $p_0, p_1,..., p_{n_{ldpc}-k_{ldpc}-1}$ to zero;
       accumulating information bit $i_0$ at parity bit accumulator addresses specified in the first row of the tabular information;
       for the next group of $m$ - 1 information bits $i_y$, where $y$ = 1, 2,..., $m$-1, accumulating each information bit at parity bit accumulator addresses $\{x + (y \bmod m) * q\} \bmod (n_{ldpc} - k_{ldpc})$, wherein $x$ denotes an address of a parity bit accumulator corresponding to the information bit $i_0$, and $q$ is a code-rate dependent constant $q$ = $(n_{ldpc} - k_{ldpc})/m$, and wherein $m$ is a code-dependent constant, wherein $m$ = 360 and $k_{ldpc}$ = $R * n_{ldpc}$, where $R$ is the code rate;
       accumulating $i_m$ at parity bit accumulator addresses specified in the second row of the tabular information, and, in a similar manner as for the group of $m$ - 1 information bits, accumulating each information bit of the next group of $m$ - 1 information bits $i_z$, $z$ = $m$ + 1, $m$ + 2,..., 2$m$ at $\{x + (z \bmod m) * q\} \bmod (n_{ldpc} - k_{ldpc})$, wherein $x$ denotes the address of the parity bit accumulator corresponding to the information bit $i_m$;
       in a similar manner, for each subsequent group of $m$ information bits, accumulating the information bits at parity bit addresses based on a next row of the tabular information; and
       after all of the information bits of the frame are accumulated, performing operations according to $p_i = p_i \oplus p_{i-1}$, wherein for $i$ = 1, 2, ..., $(n_{ldpc} - k_{ldpc} - 1)$, each $p_i$ resulting from the operation for a given $i$ is equal to the parity bit $p_i$;

| Table 1a: Address of Parity Bit Accumulators, Rate 1/5, $n_{ldpc}$=32400 |
|---|
| 18222 6715 4908 21568 22821 11708 4769 4495 22243 25872 9051 19072 13956 |
| 2038 5205 21215 21009 9584 2403 23652 20866 20130 677 9509 6136 773 |
| 19936 14590 17829 473 4432 23171 11386 17937 22084 24450 267 8822 19335 |
| 16376 16769 5111 9794 18907 827 12385 12370 21647 10938 23619 11633 15865 |
| 23417 7631 12243 21546 4192 22117 14757 4118 9686 17021 8531 15989 8807 |
| 15533 16584 18529 19699 17821 4252 1254 5952 3163 20295 6944 1022 19743 |
| 129 16579 23524 25897 14690 11222 16250 9925 4268 999 7102 24528 152 |
| 18361 3708 3454 16604 1551 5809 20324 4775 22418 19091 19674 10975 7327 |
| 24133 10950 22779 11388 13818 20668 7556 12333 16446 19684 12510 25118 8162 |
| 17026 6850 1269 |
| 21895 7137 25270 |
| 11858 24153 13303 |
| 7885 16438 12805 |
| 10473 15004 8052 |
| 2088 10379 10067 |
| 21438 13426 10440 |
| 17696 727 12164 |
| 22623 8408 17849 |

| Table 1b: Address of Parity Bit Accumulators, Rate 11/45, $n_{ldpc}$=32400 |
|---|
| 20617 6867 14845 11974 22563 190 17207 4052 7406 16007 |
| 21448 14846 2543 23380 16633 20365 16869 13411 19853 795 |
| 5200 2330 2775 23620 20643 10745 14742 6493 14222 20939 |
| 9445 9523 12769 7332 21792 18717 16397 14016 9481 22162 |
| 2922 6427 4497 4116 17658 2581 14364 3781 18851 22974 |
| 10383 2184 1433 3889 12828 17424 17580 20936 1390 21374 |
| 425 2063 22398 20907 9445 14790 4457 723 7048 4072 |
| 11771 9640 23212 9613 12042 8335 21386 20129 13521 16301 |
| 14867 12501 1086 21526 17701 17731 20907 8790 19224 5784 |
| 7107 19690 17616 5800 9501 23320 16878 794 15931 17539 |
| 4556 21783 1524 |
| 20100 11706 23663 |
| 2535 15530 6116 |
| 12078 3867 2663 |
| 19629 20246 7024 |
| 11748 11426 19802 |
| 15942 12333 5316 |
| 11521 3170 17818 |
| 2289 23780 16575 |
| 6649 16991 13025 |
| 20050 10619 10250 |
| 3944 13063 5656 |

| Table 1c: Address of Parity Bit Accumulators Rate 1/3, $n_{ldpc}$=32400 |
|---|
| 7416 4093 16722 1023 20586 12219 9175 16284 1554 10113 19849 17545 |

(continued)

| Table 1c: Address of Parity Bit Accumulators Rate 1/3, $n_{ldpc}$=32400 |
|---|
| 13140 3257 2110 13888 3023 1537 1598 15018 18931 13905 10617 1014 |
| 339 14366 3309 15360 18358 3196 4412 6023 7070 17380 2777 6691 |
| 12720 17634 4141 1400 8247 18201 16077 11314 11928 3494 3155 2865 |
| 21038 6928 3860 1943 20292 6526 12939 15182 3957 5651 356 2673 |
| 20555 17905 5724 13932 1218 17763 5912 5164 6233 6220 1277 19209 |
| 19190 4498 4950 6645 5482 5667 13701 16334 15231 735 8589 12344 |
| 679 17849 17807 16033 10181 3368 5778 8275 2736 14042 17506 6005 |
| 1576 10259 10525 3007 16522 697 7726 8641 14323 2893 8168 11070 |
| 17270 10180 18740 847 4969 14715 19316 5530 17428 11193 9861 13562 |
| 6156 18787 10467 |
| 2422 3723 10769 |
| 8015 18716 13406 |
| 5969 15949 3084 |
| 6855 13990 3764 |
| 10351 15779 10392 |
| 16078 19034 11279 |
| 11747 6608 4188 |
| 19699 8928 8045 |
| 4598 7219 11391 |
| 19766 11871 5692 |
| 7487 15905 17621 |
| 8554 7751 16516 |
| 4981 20250 16146 |
| 12524 21364 10793 |
| 17083 2051 8862 |
| 1315 6246 7721 |
| 18043 16652 5502 |
| 1432 5674 2224 |
| 11257 1312 8453 |

2. The method of claim 1, wherein the LDPC code is of a structure that facilitates use of a plurality of parallel engines for decoding the coded signal.

3. The method of any of claims 1 to 2, further comprising:

   modulating the coded LDPC frames according to according to one of the following modulation types: $\pi/2$ BPSK, where BPSK is Binary Phase Shift Keying and QPSK, wherein QPSK is Quadrature Phase Shift Keying.

4. The method of any of claims 1 to 3, wherein the source data sequence is segmented into a series of baseband frames, and the method further comprises:

   encoding each baseband frame based on a t-error BCH code, where BCH is Bose Chaudhuri Hocquenghem, wherein the BCH encoding comprises an outer coding and the LDPC encoding comprises an inner coding.

5. The method of claim 4, wherein the BCH outer coding and the LDPC inner coding are based on a one row of the following table of coding parameters depending on the code rate:

| LDPC Code Identifier | BCH uncoded block $K_{BCH}$ | BCH coded block $N_{BCH}$ LDPC uncoded block $k_{ldpc}$ | BCH t-error correction | LDPC coded block $n_{ldpc}$ |
|---|---|---|---|---|
| 1/5 | 6300 | 6480 | 12 | 32400 |
| 11/45 | 7740 | 7920 | 12 | 32400 |
| 1/3 | 10620 | 10800 | 12 | 32400 |

**6.** The method of claim 5, wherein the BCH outer coding is further based on the following table of BCH polynomials:

| $g_1(x)$ | $1+x^2+x^3+x^5+x^{15}$ |
|---|---|
| $g_2(x)$ | $1+x+x^4+x^7+x^{10}+x^{11}+x^{15}$ |
| $g_3(x)$ | $1+x^2+x^4+x^6+x^8+x^{10}+x^{12}+x^{13}+x^{15}$ |
| $g_4(x)$ | $1+x^2+x^3+x^5+x^6+x^8+x^{10}+x^{11}+x^{15}$ |
| $g_5(x)$ | $1+x+x^2+x^4+x^6+x^7+x^{10}+x^{12}+x^{15}$ |
| $g_6(x)$ | $1+x^4+x^6+x^7+x^{12}+x^{13}+x^{15}$ |
| $g_7(x)$ | $1+x^2+x^4+x^5+x^7+x^{11}+x^{12}+x^{14}+x^{15}$ |
| $g_8(x)$ | $1+x^2+x^4+x^6+x^8+x^9+x^{11}+x^{14}+x^{15}$ |
| $g_9(x)$ | $1+x+x^2+x^4+x^5+x^7+x^9+x^{11}+x^{12}+x^{13}+x^{15}$ |
| $g_{10}(x)$ | $1+x+x^2+x^3+x^4+x^7+x^{10}+x^{11}+x^{12}+x^{13}+x^{15}$ |
| $g_{11}(x)$ | $1+x+x^2+x^4+x^9+x^{11}+x^{15}$ |
| $g_{12}(x)$ | $1+x^2+x^4+x^8+x^{10}+x^{11}+x^{13}+x^{14}+x^{15}$ |

**7.** An apparatus for encoding, comprising:

at least one processor; and
at least one memory including computer program code for one or more programs,
the at least one memory and the computer program code configured to, with the at least one processor, cause the apparatus to perform at least the following:
encoding a source data sequence of information bits based on a predetermined structured parity check matrix of an LDPC code, where LDPC is Low Density Parity Check, wherein the encoding is performed based on frames of the source data sequence, each frame being of a length of $k_{ldpc}$ information bits $i_0, i_1,..., i_{k_{ldpc}-1}$, and the output of the encoding comprises coded LDPC frames each being $n_{ldpc}$ coded bits in length, wherein $n_{ldpc}$ = 32400 and
wherein the structured parity check matrix is represented by tabular information of a format wherein each row represents occurrences of one values within a respective column of the parity check matrix, and the columns of the parity check matrix are derived according to a predetermined operation based on the respective rows of the tabular information, and wherein the tabular information comprises a one of Tables **2a** through **2c;**
wherein the encoding comprises generating $n_{ldpc}$ - $k_{ldpc}$ parity bits $p_0, p_1,....,p_{n_{ldpc}-k_{ldpc}-1}$ for each frame of the source data sequence, wherein the generation of the parity bits comprises:

initializing parity bit accumulators for $p_0, p_1,..., p_{n_{ldpc}-k_{ldpc}-1}$ to zero;
accumulating information bit $i_0$ at parity bit accumulator addresses specified in the first row of the tabular information;
for the next group of $m$ - 1 information bits $i_y$, where $y$ = 1, 2, ... , $m$ - 1, accumulating each information bit at parity bit accumulator addresses $\{x + (y \bmod m) * q\} \bmod (n_{ldpc} - k_{ldpc})$, wherein $x$ denotes an address of a parity bit accumulator corresponding to the information bit $i_0$, and $q$ is a code-rate dependent constant, where $q = (n_{ldpc} - k_{ldpc})/m$ and wherein $m$ is a code-dependent constant being equal to 360 and $k_{ldpc} = R * n_{ldpc}$, where $R$ is the code rate;
accumulating $i_m$ at parity bit accumulator addresses specified in the second row of the tabular information, and, in a similar manner as for the group of $m$ - 1 information bits, accumulating each information bit of the next group of $m - 1$ information bits $i_z$, $z = m + 1$, $m + 2$,..., $2m$ at $\{x + (z \bmod m) * q\} \bmod (n_{ldpc} - k_{ldpc})$, wherein $x$ denotes the address of the parity bit accumulator corresponding to the information bit $i_m$;

in a similar manner, for each subsequent group of $m$ information bits, accumulating the information bits at parity bit addresses based on a next row of the tabular information; and

after all of the information bits of the frame are accumulated, performing operations according to $p_i = p_i \oplus p_{i-1}$, wherein for $i = 1,2,...,(n_{ldpc} - k_{ldpc} - 1)$, each $p_i$ resulting from the operation for a given $i$ is equal to the parity bit $p_i$;

| Table 2a: Address of Parity Bit Accumulators, Rate 1/5, $n_{ldpc}$=32400 |
|---|
| 18222 6715 4908 21568 22821 11708 4769 4495 22243 25872 9051 19072 13956 |
| 2038 5205 21215 21009 9584 2403 23652 20866 20130 677 9509 6136 773 |
| 19936 14590 17829 473 4432 23171 11386 17937 22084 24450 267 8822 19335 |
| 16376 16769 5111 9794 18907 827 12385 12370 21647 10938 23619 11633 15865 |
| 23417 7631 12243 21546 4192 22117 14757 4118 9686 17021 8531 15989 8807 |
| 15533 16584 18529 19699 17821 4252 1254 5952 3163 20295 6944 1022 19743 |
| 129 16579 23524 25897 14690 11222 16250 9925 4268 999 7102 24528 152 |
| 18361 3708 3454 16604 1551 5809 20324 4775 22418 19091 19674 10975 7327 |
| 24133 10950 22779 11388 13818 20668 7556 12333 16446 19684 12510 25118 8162 |
| 17026 6850 1269 |
| 21895 7137 25270 |
| 11858 24153 13303 |
| 7885 16438 12805 |
| 10473 15004 8052 |
| 2088 10379 10067 |
| 21438 13426 10440 |
| 17696 727 12164 |
| 22623 8408 17849 |

| Table 2b: Address of Parity Bit Accumulators, Rate 11/45 $n_{ldpc}$=32400 |
|---|
| 20617 6867 14845 11974 22563 190 17207 4052 7406 16007 |
| 21448 14846 2543 23380 16633 20365 16869 13411 19853 795 |
| 5200 2330 2775 23620 20643 10745 14742 6493 14222 20939 |
| 9445 9523 12769 7332 21792 18717 16397 14016 9481 22162 |
| 2922 6427 4497 4116 17658 2581 14364 3781 18851 22974 |
| 10383 2184 1433 3889 12828 17424 17580 20936 1390 21374 |
| 425 2063 22398 20907 9445 14790 4457 723 7048 4072 |
| 11771 9640 23212 9613 12042 8335 21386 20129 13521 16301 |
| 14867 12501 1086 21526 17701 17731 20907 8790 19224 5784 |
| 7107 19690 17616 5800 9501 23320 16878 794 15931 17539 |
| 4556 21783 1524 |
| 20100 11706 23663 |
| 2535 15530 6116 |
| 12078 3867 2663 |
| 19629 20246 7024 |
| 11748 11426 19802 |
| 15942 12333 5316 |
| 11521 3170 17818 |
| 2289 23780 16575 |
| 6649 16991 13025 |
| 20050 10619 10250 |

(continued)

| Table 2b: Address of Parity Bit Accumulators, Rate 11/45 $n_{ldpc}$=32400 |
| --- |
| 3944 13063 5656 |

| Table 2c: Address of Parity Bit Accumulators, Rate 1/3, $n_{ldpc}$=32400 |
| --- |
| 7416 4093 16722 1023 20586 12219 9175 16284 1554 10113 19849 17545 |
| 13140 3257 2110 13888 3023 1537 1598 15018 18931 13905 10617 1014 |
| 339 14366 3309 15360 18358 3196 4412 6023 7070 17380 2777 6691 |
| 12720 17634 4141 1400 8247 18201 16077 11314 11928 3494 3155 2865 |
| 21038 6928 3860 1943 20292 6526 12939 15182 3957 5651 356 2673 |
| 20555 17905 5724 13932 1218 17763 5912 5164 6233 6220 1277 19209 |
| 19190 4498 4950 6645 5482 5667 13701 16334 15231 735 8589 12344 |
| 679 17849 17807 16033 10181 3368 5778 8275 2736 14042 17506 6005 |
| 1576 10259 10525 3007 16522 697 7726 8641 14323 2893 8168 11070 |
| 17270 10180 18740 847 4969 14715 19316 5530 17428 11193 9861 13562 |
| 6156 18787 10467 |
| 2422 3723 10769 |
| 8015 18716 13406 |
| 5969 15949 3084 |
| 6855 13990 3764 |
| 10351 15779 10392 |
| 16078 19034 11279 |
| 11747 6608 4188 |
| 19699 8928 8045 |
| 4598 7219 11391 |
| 19766 11871 5692 |
| 7487 15905 17621 |
| 8554 7751 16516 |
| 4981 20250 16146 |
| 12524 21364 10793 |
| 17083 2051 8862 |
| 1315 6246 7721 |
| 18043 16652 5502 |
| 1432 5674 2224 |
| 11257 1312 8453 |

8. The apparatus of claim 7, wherein the LDPC code is of a structure that facilitates use of a plurality of parallel engines for decoding the coded signal.

9. The apparatus of any of claims 7 to 8, wherein the apparatus is caused to further perform:

modulating the coded LDPC frames according to according to one of the following modulation types: $\pi/2$ BPSK, where BPSK is Binary Phase Shift Keying, and QPSK, where QPSK is Quadrature Phase Shift Keying.

10. The apparatus of any of claims 7 to 9, wherein the source data sequence is segmented into a series of baseband frames, and the apparatus is caused to further perform:

encoding each baseband frame based on a t-error BCH code, where BCH is Bose Chaudhuri Hocquenghem, wherein the BCH encoding comprises an outer coding and the LDPC encoding comprises an inner coding.

**11.** The apparatus of claim 10, wherein the BCH outer coding and the LDPC inner coding are based on a one row of the following table of coding parameters depending on the code rate:

| LDPC Code Identifier | BCH uncoded block $K_{BCH}$ | BCH coded block $N_{BCH}$ LDPC uncoded block $k_{ldpc}$ | BCH t-error correction | LDPC coded block $n_{ldpc}$ |
|---|---|---|---|---|
| 1/5 | 6300 | 6480 | 12 | 32400 |
| 11/45 | 7740 | 7920 | 12 | 32400 |
| 1/3 | 10620 | 10800 | 12 | 32400 |

**12.** The apparatus of claim 11, wherein the BCH outer coding is further based on the following table of BCH polynomials:

| | |
|---|---|
| $g_1(x)$ | $1+x^2+x^3+x^5+x^{15}$ |
| $g_2(x)$ | $1+x+x^4+x^7+x^{10}+x^{l1}+x^{15}$ |
| $g_3(x)$ | $1+x^2+x^4+x^6+x^8+x^{10}+x^{12}+x^{13}+x^{15}$ |
| $g_4(x)$ | $1+x^2+x^3+x^5+x^6+x^8+x^{10}+x^{11}+x^{15}$ |
| $g_5(x)$ | $1+x+x^2+x^4+x^6+x^7+x^{10}+x^{12}+x^{15}$ |
| $g_6(X)$ | $1+x^4+x^6+x^7+x^{12}+x^{13}+x^{15}$ |
| $g_7(x)$ | $1+x^2+x^4+x^5+x^7+x^{11}+x^{12}+x^{14}+x^{15}$ |
| $g_8(x)$ | $1+x^2+x^4+x^6+x^8+x^9+x^{11}+x^{14}+x^{15}$ |
| $g_9(x)$ | $1+x+x^2+x^4+x^5+x^7+x^9+x^{11}+x^{12}+x^{13}+x^{15}$ |
| $g_{10}(x)$ | $1+x+x^2+x^3+x^4+x^7+x^{10}+x^{11}+x^{12}+x^{13}+x^{15}$ |
| $g_{11}(x)$ | $1+x+x^2+x^4+x^9+x^{11}+x^{15}$ |
| $g_{12}(x)$ | $1+x^2+x^4+x^8+x^{10}+x^{11}+x^{13}+x^{14}+x^{15}$ |

**13.** Computer program with program code means in order to perform all steps according to any of claims 1 to 6, when the program runs on a computer or a digital signal processor.

**Patentansprüche**

**1.** Verfahren zum Codieren, umfassend:

Codieren einer Quelldatenfolge von Informationsbits mittels eines Prozessors einer Vorrichtung auf der Grundlage einer bestimmten strukturierten Paritätskontrollmatrix eines LDPC-Codes, wobei der LDPC-Code ein Paritätskontroll-Code geringer Dichte ist, wobei die Codierung auf der Grundlage von Rahmen der Quelldatenfolge ausgeführt wird, wobei jeder Rahmen von einer Länge von $k_{ldpc}$ Informationsbits $i_0$, $i_1$, ..., $I_{kldpc-1}$ ist und das Ausgangssignal der Codierung codierte LDPC-Rahmen umfasst, die jeweils in der Länge $n_{ldpc}$ codierte Bits aufweisen, wobei $n_{ldpc}$ =32400 beträgt,
wobei die strukturierte Paritätskontrollmatrix durch eine tabellarische Information eines Formats dargestellt wird, in welchem jede Zeile Auftritte von einen Werten innerhalb einer jeweiligen Spalte der Paritätskontrollmatrix darstellt und die Spalten der Paritätskontrollmatrix entsprechend einer bestimmten Operation auf der Grundlage der jeweiligen Zeilen der tabellarischen Information abgeleitet werden,
wobei die tabellarische Information eine von Tabellen 1a bis 1c umfasst,
wobei die Codierung die Erzeugung von $n_{ldpc}$-$k_{dpc}$ Paritätsbits $p_0$, $p_1$,..., $p_{nldpc-kldpc}$-1 für jeden Rahmen der Quelldatenfolge umfasst, wobei die Erzeugung der Paritätsbits umfasst:

Initialisieren von Paritätsbit-Akkumulatoren für $p_0$, $p_1$,..., $p_{nldpc-kldpc}$-1 auf Null,
Akkumulieren des Informationsbits $i_0$ unter den in der ersten Zeile der tabellarischen Information spezifizierten Paritätsbit-Akkumulatoradressen,

für die nächste Gruppe von m - 1 Informationsbits $i_y$, mit y = 1, 2, ..., m - 1, Akkumulieren jedes Informationsbits unter den Paritätsbit-Akkumulatoradressen, {x + (y mod m)*q}mod($n_{ldpc}$- $k_{ldpc}$), worin x eine Adresse eines Paritätsbit-Akkumulators entsprechend dem Informationsbit $i_0$ angibt, und q eine coderatenabhängige Konstante mit q = ($n_{ldpc}$ - $k_{ldpc}$) /m ist und worin m eine codeabhängige Konstante ist, worin m gleich 360 ist und $k_{ldpc}$ = R*$n_{ldpc}$ ist und wobei R die Coderate ist, Akkumulieren von $i_m$ unter den in der zweiten Zeile der tabellarischen Information spezifizierten Akkumulatoradressen,

und in einer ähnlichen Weise wie für die Gruppe von m - 1 Informationsbits Akkumulieren jedes Informationsbit der nächsten Gruppe von m-1 Informationsbits $i_z$, z = m + 1, m + 2,..., 2m bei {x + (z mod m)*q}mod ($n_{ldpc}$ - $k_{ldpc}$), worin x die Adresse des Paritätsbitakkumulators entsprechend dem Informationsbit $i_m$ angibt, in einer ähnlichen Weise für jede nachfolgende Gruppe von m Informationsbits Akkumulieren der Informationsbits unter den Paritätsbit-Adressen auf der Grundlage einer nächsten Zeile der tabellarischen Information, und nachdem die Informationsbits des Rahmens akkumuliert sind, Ausführen von Operationen entsprechend $p_i = p_i \oplus p_{i-1}$, worin i = 1,2,..., ($n_{ldpc}$ - $k_{ldpc}$ - 1) ist, wobei jedes $p_i$, das aus der Operation für ein gegebenes i resultiert, gleich dem Paritätsbit $p_i$ ist.

| Tabelle 1a: Adresse von Paritätsbit-Akkumulatoren (Rate 1/5) ($n_{ldpc}$=32400) |
|---|
| 18222 6715 4908 21568 22821 11708 4769 4495 22243 25872 9051 19072 13956 |
| 2038 5205 21215 21009 9584 2403 23652 20866 20130 677 9509 6136 773 |
| 19936 14590 17829 473 4432 23171 11386 17937 22084 24450 267 8822 19335 |
| 16376 16769 5111 9794 18907 827 12385 12370 21647 10938 23619 11633 15865 |
| 23417 7631 12243 21546 4192 22117 14757 4118 9686 17021 8531 15989 8807 |
| 15533 16584 18529 19699 17821 4252 1254 5952 3163 20295 6944 1022 19743 |
| 129 16579 23524 25897 14690 11222 16250 9925 4268 999 7102 24528 152 |
| 18361 3708 3454 16604 1551 5809 20324 4775 22418 19091 19674 10975 7327 |
| 24133 10950 22779 11388 13818 20668 7556 12333 16446 19684 12510 25118 8162 |
| 17026 6850 1269 |
| 21895 7137 25270 |
| 11858 24153 13303 |
| 7885 16438 12805 |
| 10473 15004 8052 |
| 2088 10379 10067 |
| 21438 13426 10440 |
| 17696 727 12164 |
| 22623 8408 17849 |

| Tabelle 1b: Adresse von Paritätsbit-Akkumulatoren (Rate 11/45) ($n_{ldpc}$=32400) |
|---|
| 20617 6867 14845 11974 22563 190 17207 4052 740616007 |
| 21448 14846 2543 23380 16633 20365 16869 13411 19853 795 |
| 5200 2330 2775 23620 20643 10745 14742 6493 14222 20939 |
| 9445 9523 12769 7332 21792 18717 16397 14016 9481 22162 |
| 2922 6427 4497 4116 17658 2581 14364 3781 18851 22974 |
| 10383 2184 1433 3889 12828 17424 17580 20936 1390 21374 |
| 425 2063 22398 20907 9445 14790 4457 723 7048 4072 |
| 11771 9640 23212 9613 12042 8335 21386 20129 13521 16301 |
| 14867 12501 1086 21526 17701 17731 20907 8790 19224 5784 |
| 7107 19690 17616 5800 9501 23320 16878 794 15931 17539 |
| 4556 21783 1524 |
| 20100 11706 23663 |
| 2535 15530 6118 |
| 12078 3867 2663 |

(fortgesetzt)

| Tabelle 1b: Adresse von Paritätsbit-Akkumulatoren (Rate 11/45) ($n_{ldpc}$=32400) |
|---|
| 19B29 20246 7024 |
| 11748 11426 19802 |
| 15942 12333 5316 |
| 11521 3170 17818 |
| 2289 23780 16575 |
| 6649 16991 13025 |
| 20050 10619 10250 |
| 3944 13063 5656 |

| Tabelle 1c: Adresse von Paritätsbit-Akkumulatoren (Rate 1/3) ($n_{ldpc}$=32400) |
|---|
| 7416 4093 16722 1023 20586 12219 9175 16284 1554 101131984917545 |
| 13140 3257 2110 13888 3023 1537 1598 15018 18931 13905 10617 1014 |
| 339 14366 3309 15360 18358 3196 4412 6023 7070 17380 2777 6691 |
| 12720 17634 4141 1400 8247 18201 16077 11314 11928 3494 3155 2865 |
| 21038 6928 3860 1943 20292 6526 12939 15182 3957 5651 356 2673 |
| 20555 17905 5724 13932 1218 17763 5912 5164 6233 6220 1277 19209 |
| 19190 4498 4950 6645 5482 5667 13701 16334 15231 735 8589 12344 |
| 679 17849 17807 16033 10181 3368 5778 8275 2736 14042 17506 6005 |
| 1576 10259 10525 3007 16522 697 7726 8641 14323 2893 8168 11070 |
| 17270 10180 18740 847 4969 14715 19316 5530 17428 11193 9861 13562 |
| 6156 18787 10467 |
| 2422 3723 10769 |
| 8015 18716 13406 |
| 5969 15949 3084 |
| 6855 13990 3764 |
| 10351 15779 10392 |
| 16078 19034 11279 |
| 11747 6608 4188 |
| 19699 8928 8045 |
| 4598 7219 11391 |
| 19766 11871 5692 |
| 7487 15905 17621 |
| 8554 7751 16516 |
| 4981 20250 16146 |
| 12524 21364 10793 |
| 17083 2051 8862 |
| 1315 6246 7721 |
| 18043 16652 5502 |
| 1432 5674 2224 |
| 11257 1312 8453 |

2. Verfahren nach Anspruch 1, wobei der LDPC-Code von einer Struktur ist, welche die Nutzung einer Vielzahl von parallelen Maschinen zur Decodierung des codierten Signals erleichtert.

3. Verfahren nach einem der Ansprüche 1 bis 2, ferner umfassend:

Modulieren der codierten LDPC-Rahmen entsprechend einem der folgenden Modulationstypen: n/2-BPSK, wobei BPSK eine binäre Phasenumtastung ist, und QPSK, wobei QPSK eine Quadratur-Phasenumtastung ist.

4. Verfahren nach einem der Ansprüche 1 bis 3, wobei die Quelldatenfolge in eine Reihe von Basisbandrahmen segmentiert wird,
wobei das Verfahren ferner umfasst:

Codieren jedes Basisbandrahmens auf der Grundlage eines t-Fehler-BCH-Codes, wobei der BCH-Code ein Bose-Chaudhuri-Hocquenghem-Code ist
und wobei die BCH-Codierung eine äußere Codierung umfasst und die LDPC-Codierung eine innere Codierung umfasst.

5. Verfahren nach Anspruch 4, wobei die äußere BCH-Codierung und die innere LDPC-Codierung auf einer Zeile der folgenden Tabelle in Abhängigkeit von der Coderate basieren:

| LDPC-Code-Kennzeichnung | BCH-uncodierter Block $K_{BCH}$ | BCH-codierter Block $N_{BCH}$ LDPC-uncodierter Block $k_{ldpc}$ | BCH-t-Fehlerkorrektur | LDPC-codierter Block $n_{ldpc}$ |
|---|---|---|---|---|
| 1/5 | 6300 | 6480 | 12 | 32400 |
| 11/45 | 7740 | 7920 | 12 | 32400 |
| 1/3 | 10620 | 10800 | 12 | 32400 |

6. Verfahren nach Anspruch 5, wobei die äußere BCH-Codierung ferner auf der folgenden Tabelle von Polynomen basiert:

| | |
|---|---|
| $g_1(x)$ | $1+x^2+x^3+x^5+x^{15}$ |
| $g_2(x)$ | $1+x+x^4+x^7+x^{10}+x^{11}+x^{15}$ |
| $g_3(x)$ | $1+x^2+x^4+x^6+x^8+x^{10}+x^{12}+x^{13}+x^{15}$ |
| $g_4(x)$ | $1+x^2+x^3+x^5+x^6+x^6+x^8+x^{10}+x^{11}+x^{15}$ |
| $g_5(x)$ | $1+x+x^2+x^4+x^6+x^7+x^{10}+x^{12}+x^{15}$ |
| $g_6(x)$ | $1+x^4+x^6+x^7+x^{12}+x^{13}+x^{15}$ |
| $g_7(x)$ | $1+x^2+x^4+x^5+x^7+x^{11}-x^{12}+x^{14}+x^{15}$ |
| $g_8(x)$ | $1+x^2+x^4+x^6+x^8+x^9+x^{11}+x^{14}+x^{15}$ |
| $g_9(x)$ | $1+x+x^2+x^4+x^5+x^7+x^9+x^{11}+x^{12}+x^{13}+x^{15}$ |
| $g_{10}(x)$ | $1+x+x^2+x^3+x^4+x^7+x^{10}+x^{11}+x^{12}+x^{13}+x^{15}$ |
| $g_{11}(x)$ | $1+x+x^2+x^4+x^9+x^{11}+x^{15}$ |
| $g_{12}(x)$ | $1+x^2+x^4+x^8+x^{10}+x^{11}+x^{13}+x^{14}+x^{15}$ |

7. Vorrichtung zum Codieren, umfassend zumindest einen Prozessor und zumindest einen Speicher, der einen Computerprogrammcode für ein oder mehrere Programme enthält,
wobei der zumindest eine Speicher und der Computerprogrammcode konfiguriert sind, um mit dem zumindest einen Prozessor die Vorrichtung zu veranlassen, zumindest folgendes auszuführen:

Codieren einer Quelldatenfolge von Informationsbits auf der Grundlage einer bestimmten strukturierten Paritätskontrollmatrix eines LDPC-Codes, wobei der LDPC-Code ein Paritätskontrollcode geringer Dichte ist, wobei die Codierung auf der Grundlage von Rahmen der Quelldatenfolge ausgeführt wird,
wobei jeder Rahmen von einer Länge von $k_{ldpc}$ Informationsbits $i_0, i_1, ....., i_{k_{ldpc}-1}$ ist und das Ausgangssignal der Codierung codierte LDPC-Rahmen jeweils mit $n_{ldpc}$ codierten Bits in der Länge umfasst,
wobei $n_{ldpc} = 32400$ ist,

wobei die strukturierte Paritätskontrollmatrix durch eine tabellarische Information eines Formats dargestellt ist, in welchem jede Zeile Auftritte von einen Werten innerhalb einer jeweiligen Spalte der Paritätskontrollmatrix darstellt und die Spalten der Paritätskontrollmatrix entsprechend einer bestimmten Operation auf der Grundlage der jeweiligen Zeilen der tabellenartigen Information abgeleitet sind und wobei die tabellarische Information eine von Tabellen 2a bis 2c umfasst,

wobei die Codierung die Erzeugung von $n_{ldpc} - k_{ldpc}$ Paritätsbits $p_0, p_1,..., p_{n_{ldpc}-k_{ldpc}-1}$ für jeden Rahmen der Quelldatenfolge umfasst, wobei die Erzeugung der Paritätsbits umfasst:

Initialisieren von Paritätsbit-Akkumulatoren für $p_0, p_1,..., p_{n_{ldpc}-k_{ldpc}-1}$ auf Null,
Akkumulieren des Informationsbits $i_0$ unter den in der ersten Zeile der tabellarischen Information spezifizierten Paritätsbit-Akkumulatoradressen, für die nächste Gruppe von m - 1 Informationsbits $i_y$, mit y = 1, 2, ..., m - 1, Akkumulieren jedes Informationsbits unter den Paritätsbit-Akkumulatoradressen {x + (y mod m)*q}mod($n_{ldpc}$ - $k_{ldpc}$), worin x eine Adresse eines Paritätsbit-Akkumulators entsprechend dem Informationsbit io und q eine coderatenabhängige Konstante mit q = ($n_{ldpc}$ - $k_{ldpc}$) /m angeben und worin m eine codeabhängige Konstante ist, die gleich 360 ist, und $k_{ldpc} = R*n_{ldpc}$ ist, wobei R die Coderate ist,
Akkumulieren von $i_m$ unter den in der zweiten Zeile der tabellarischen Information spezifizierten Akkumulatoradressen,
und in einer ähnlichen Weise wie für die Gruppe von m - 1 Informationsbits Akkumulieren jedes Informationsbit der nächsten Gruppe von m - 1 Informationsbits $i_z$, z = m + 1, m + 2,..., 2m bei {x + (z mod m) *q} mod($n_{ldpc}$ - $k_{ldpc}$), worin x die Adresse des Paritätsbitakkumulators entsprechend dem Informationsbit $i_m$ angibt,
in einer ähnlichen Weise für jede nachfolgende Gruppe von m Informationsbits Akkumulieren der Informationsbits unter den Paritätsbit-Adressen auf der Grundlage einer nächsten Zeile der tabellarischen Information, und nachdem die Informationsbits des Rahmens akkumuliert sind, Ausführen von Operationen entsprechend $p_i = p_i \oplus p_{i-1}$, worin i = 1,2,..., ($n_{ldpc}$ - $k_{ldpc}$ - 1) ist, wobei jedes $p_i$, das aus der Operation für ein gegebenes i resultiert, gleich dem Paritätsbit $p_i$ ist;

| Tabelle 2a: Adresse von Paritätsbit-Akkumulatoren (Rate 1/5) ($n_{ldpc}$=32400) |
|---|
| 18222 6715 4908 21568 22821 11708 4769 4495 22243 25872 9051 19072 13956 |
| 2038 5205 21215 21009 9584 2403 23652 20866 20130 677 9509 6136 773 |
| 19936 14590 17829 473 4432 23171 11386 17937 22084 24450 267 8822 19335 |
| 16376 16769 5111 9794 18907 827 12385 12370 21647 10938 23619 11633 15865 |
| 23417 7631 12243 21546 4192 22117 14757 4118 9686 17021 8531 15989 8807 |
| 15533 16584 18529 19699 17821 4252 1254 5952 3163 20295 6944 1022 19743 |
| 129 16579 23524 25897 14690 11222 16250 9925 4268 999 7102 24528 152 |
| 18361 3708 3454 16604 1551 5809 20324 4775 22418 19091 19674 10975 7327 |
| 24133 10950 22779 11388 13818 20668 7556 12333 16446 19684 12510 25118 8162 |
| 17026 6850 1269 |
| 21895 7137 25270 |
| 11858 24153 13303 |
| 7885 16438 12805 |
| 10473 15004 8052 |
| 2088 10379 10067 |
| 21438 13426 10440 |
| 17696 727 12164 |
| 22623 8408 17849 |

| Tabelle 2b: Adresse von Paritätsbit-Akkumulatoren (Rate 11/45) ($n_{ldpc}$=32400) |
|---|
| 20617 6867 14845 11974 22563 190 17207 4052 7406 16007 |
| 21448 14846 2543 23380 16633 20365 16869 13411 19853 795 |
| 5200 2330 2775 23620 20643 10745 14742 6493 14222 20939 |
| 9445 9523 12769 7332 21792 18717 16397 14016 9481 22162 |

(fortgesetzt)

| Tabelle 2b: Adresse von Paritätsbit-Akkumulatoren (Rate 11/45) ($n_{ldpc}$=32400) |
| --- |
| 2922 6427 4497 4116 17658 2581 14364 3781 18851 22974 |
| 10383 2184 1433 3889 12828 17424 17580 20936 1390 21374 |
| 425 2063 22398 20907 9445 14790 4457 723 7048 4072 |
| 11771 9640 23212 9613 12042 8335 21386 20129 13521 16301 |
| 14867 12501 1086 21526 17701 17731 20907 8790 19224 5784 |
| 7107 19690 17616 5800 9501 23320 16878 794 15931 17539 |
| 4556 21783 1524 |
| 20100 11706 23663 |
| 2535 15530 6116 |
| 12078 3867 2663 |
| 19629 20246 7024 |
| 11748 11426 19802 |
| 15942 12333 5316 |
| 11521 3170 17818 |
| 2289 23780 16575 |
| 6649 16991 13025 |
| 20050 10619 10250 |
| 3944 13063 5656 |

| Tabelle 2c: Adresse von Paritätsbit-Akkumulatoren (Rate 1/3) ($n_{ldpc}$=32400) |
| --- |
| 74164093167221023 2058612219917516284 1554 10113 19849 17545 |
| 13140 3257 2110 13888 3023 1537 1598 15018 18931 13905 10617 1014 |
| 339 14366 3309 15360 18358 3196 4412 6023 7070 17380 2777 6691 |
| 12720 17634 4141 1400 8247 18201 16077 11314 11928 3494 3155 2865 |
| 21038 6928 3860 1943 20292 6526 12939 15182 3957 5651 356 2673 |
| 20555 17905 5724 13932 1218 17763 5912 5164 6233 6220 1277 19209 |
| 19190 4498 4950 6645 5482 5667 13701 16334 15231 735 8589 12344 |
| 679 17849 17807 16033 10181 3368 5778 8275 2736 14042 17506 6005 |
| 1576 10259 10525 3007 16522 697 7726 8641 14323 2893 8168 11070 |
| 17270 10180 18740 847 4969 14715 19316 5530 17428 11193 9861 13562 |
| 6156 18787 10467 |
| 2422 3723 10769 |
| 8015 18716 13406 |
| 5969 15949 3084 |
| 6855 13990 3764 |
| 10351 15779 10392 |
| 16078 19034 11279 |
| 11747 6608 4188 |
| 19699 8928 8045 |
| 4598 7219 11391 |
| 19766 11871 5692 |
| 7487 15905 17621 |
| 8554 7751 16516 |
| 4981 20250 16146 |
| 12524 21364 10793 |
| 17083 2051 8862 |
| 1315 6246 7721 |

(fortgesetzt)

| Tabelle 2c: Adresse von Paritätsbit-Akkumulatoren (Rate 1/3) ($n_{ldpc}$=32400) |
|---|
| 18043 16652 5502 |
| 1432 5674 2224 |
| 11257 1312 8453 |

**8.** Vorrichtung nach Anspruch 7, wobei der LDPC-Code von einer Struktur ist, welche die Nutzung einer Vielzahl von parallelen Maschinen zur Decodierung des codierten Signals erleichtert.

**9.** Vorrichtung nach einem der Ansprüche 7 bis 8, wobei die Vorrichtung veranlasst ist, ferner auszuführen:

Modulieren der codierten LDPC-Rahmen entsprechend einem der folgenden Modulationstypen: n/2-BPSK, wobei BPSK eine binäre Phasenumtastung ist, und QPSK, wobei QPSK eine Quadratur-Phasenumtastung ist.

**10.** Vorrichtung nach einem der Ansprüche 7 bis 9, wobei die Quelldatenfolge in eine Reihe von Basisbandrahmen segmentiert wird,
wobei die Vorrichtung veranlasst ist, ferner auszuführen:

Codieren jedes Basisbandrahmens auf der Grundlage eines t-Fehler-BCH-Codes, wobei der BCH-Code ein Bose-Chaudhuri-Hocquenghem-Code ist
und wobei die BCH-Codierung eine äußere Codierung umfasst und die LDPC-Codierung eine innere Codierung umfasst.

**11.** Vorrichtung nach Anspruch 10, wobei die äußere BCH-Codierung und die innere LDPC-Codierung auf einer Zeile der folgenden Tabelle in Abhängigkeit von der Coderate basieren:

| LDPC-Code-Kennzeichnung | BCH-uncodierter Block $K_{BCH}$ | BCH-codierter Block $N_{BCH}$ LDPC-uncodierter Block $k_{ldpc}$ | BCH-t-Fehlerkorrektur | LDPC-codierter Block $n_{ldpc}$ |
|---|---|---|---|---|
| 1/5 | 6300 | 6480 | 12 | 32400 |
| 11/45 | 7740 | 7920 | 12 | 32400 |
| 1/3 | 10620 | 10800 | 12 | 32400 |

**12.** Vorrichtung nach Anspruch 11, wobei die äußere BCH-Codierung ferner auf der folgenden Tabelle von Polynomen basiert:

| | |
|---|---|
| $g_1(x)$ | $1+x^2+x^3+x^5+x^{15}$ |
| $g_2(x)$ | $1+x+x^4+x^7+x^{10}+x^{11}+x^{15}$ |
| $g_3(x)$ | $1+x^2+x^4+x^6+x^8+x^{10}+x^{12}+x^{13}+x^{15}$ |
| $g_4(x)$ | $1+x^2+x^3+x^5+x^6+x^8+x^{10}+x^{11}+x^{15}$ |
| $g_5(x)$ | $1+x+x^2+x^4+x^6+x^7+x^{10}+x^{12}+x^{15}$ |
| $g_6(x)$ | $1+x^4+x^6+x^7+x^{12}+x^{13}+x^{15}$ |
| $g_7(x)$ | $1+x^2+x^4+x^5+x^7+x^{11}+x^{12}+x^{14}+x^{15}$ |
| $g_8(x)$ | $1+x^2+x^4+x^6+x^8+x^9+x^{11}+x^{14}+x^{15}$ |
| $g_9(x)$ | $1+x+x^2+x^4+x^5+x^7+x^9+x^{11}+x^{12}+x^{13}+x^{15}$ |
| $g_{10}(x)$ | $1+x+x^2+x^3+x^4+x^7+x^{10}+x^{11}+x^{12}+x^{13}+x^{15}$ |
| $g_{11}(x)$ | $1+x+x^2+x^4+x^9+x^{11}+x^{15}$ |

(fortgesetzt)

| $g_{12}(x)$ | $1+x^2+x^4+x^8+x^{10}+x^{11}+x^{13}+x^{14}+x^{15}$ |
|---|---|

**13.** Computerprogramm mit Programmcodemitteln, um die Schritte nach einem der Ansprüche 1 bis 6 auszuführen, wenn das Programm in einem Computer oder einem digitalen Signalprozessor abläuft.

**Revendications**

**1.** Procédé pour encoder comprenant :

l'encodage, par un processeur d'un dispositif, d'une séquence de données source de bits d'information sur la base d'une matrice de contrôle de parité structurée prédéterminée d'un code LDPC, où LDPC est un Contrôle de parité à faible densité (Low Density Parity Check), où l'encodage est effectué sur la base de trames de la séquence de données source, chaque trame étant d'une longueur de $k_{ldpc}$ bits d'information $i_0$, $i_1$, ..., $i_{k_{ldpc}-1}$, et la sortie de l'encodage comprend des trames LDPC codées, chacune étant de $n_{ldpc}$ bits codés de longueur, où $n_{ldpc}$ = 32400 et

dans lequel la matrice de contrôle de parité structurée est représentée par des informations tabulaires d'un format dans lequel chaque rangée représente des occurrences d'une valeur à l'intérieur d'une colonne respective de la matrice de contrôle de parité, et les colonnes de la matrice de contrôle de parité sont dérivées selon une opération prédéterminée sur la base des rangées respectives des informations tabulaires, et dans lequel les informations tabulaires comprennent une des Tables **1a** à **1c ;**

dans lequel l'encodage comprend la génération de $n_{ldpc}$ - $k_{ldpc}$ bits de parité $p_0$, $p_1$,...,$p_{n_{ldpc}-k_{ldpc}-1}$ pour chaque trame de la séquence de données source, dans lequel la génération des bits de parité comprend :

l'initialisation d'accumulateurs de bit de parité pour $p_0$, $p_1$,...,$p_{n_{ldpc}-k_{ldpc}-1}$ à zéro ;
l'accumulation de bit d'information $i_0$ à des adresses d'accumulateur de bit de parité spécifiées dans la première rangée des informations tabulaires ;
pour le groupe suivant de $m$ - 1 bits d'information $i_y$, où $y$=1,2,...,$m$-1, l'accumulation de chaque bit d'information à des adresses d'accumulateur de bit de parité {$x$ + ($y$ mod $m$) * $q$} mod ($n_{ldpc}$ - $k_{ldpc}$), où $x$ désigne une adresse d'un accumulateur de bit de parité correspondant au bit d'information $i_0$, et $q$ est une constante dépendante du débit de code $q = (n_{ldpc} - k_{ldpc})/m$, et où $m$ est une constante dépendante du code, où $m$ = 360 et $k_{ldpc} = R * n_{ldpc}$, où $R$ est le débit de code ;
l'accumulation d' $i_m$ à des adresses d'accumulateur de bit de parité spécifiées dans la deuxième rangée des informations tabulaires, et, d'une manière similaire à celle pour le groupe de $m$ - 1 bits d'information, l'accumulation de chaque bit d'information du groupe suivant de $m$ - 1 bits d'information $i_z$, $z = m + 1$, $m +$ 2,..., 2$m$ à {$x$ + ($z$ mod $m$) * $q$} $mod$ ($n_{ldpc}$ - $k_{ldpc}$), où $x$ désigne l'adresse de l'accumulateur de bit de parité correspondant au bit d'information $i_m$ ;
de manière similaire, pour chaque groupe subséquent de $m$ bits d'information, l'accumulation des bits d'information à des adresses de bit de parité sur la base d'une rangée suivante des informations tabulaires ; et
après que tous les bits d'information de la trame sont accumulés, l'exécution d'opérations selon $p_i = p_i \oplus p_{i-1}$, où pour $i$ = 1, 2,..., ($n_{ldpc}$ - $k_{ldpc}$ - 1), chaque $p_i$ résultant de l'opération pour un $i$ donné est égal au bit de parité $p_i$;

| **Table 1a : Adresse d'accumulateurs de bit de parité, Débit 1/5, $n_{ldpc}$=32400** |
|---|
| 18222 6715 4908 21568 22821 11708 4769 4495 22243 25872 |
| 9051 19072 13956<br>2038 5205 21215 21009 9584 2403 23652 20866 20130 677 9509 6136 773<br>19936 14590 17829 473 4432 23171 11386 17937 22084 24450 267 8822 19335<br>16376 16769 5111 9794 18907 827 12385 12370 21647 10938 23619 11633 15865<br>23417 7631 12243 21546 4192 22117 14757 4118 9686 17021 8531 15989 8807<br>15533 16584 18529 19699 17821 4252 1254 5952 3163 20295 6944 1022 19743<br>129 16579 23524 25897 14690 11222 16250 9925 4268 999 7102 24528 152 |

(suite)

| Table 1a : Adresse d'accumulateurs de bit de parité, Débit 1/5, $n_{ldpc}$=32400 |
|---|
| 18361 3708 3454 16604 1551 5809 20324 4775 22418 19091 19674 10975 7327 |
| 24133 10950 22779 11388 13818 20668 7556 12333 16446 19684 |
| 12510 25118 8162 |
| 17026 6850 1269 |
| 21895 7137 25270 |
| 11858 24153 13303 |
| 7885 16438 12805 |
| 10473 15004 8052 |
| 2088 10379 10067 |
| 21438 13426 10440 |
| 17696 727 12164 |
| 22623 8408 17849 |

| Table 1b : Adresse d'accumulateurs de bit de parité, Débit 11/45, $n_{ldpc}$=32400 |
|---|
| 20617 6867 14845 11974 22563 190 17207 4052 7406 16007 |
| 21448 14846 2543 23380 16633 20365 16869 13411 19853 795 |
| 5200 2330 2775 23620 20643 10745 14742 6493 14222 20939 |
| 9445 9523 12769 7332 21792 18717 16397 14016 9481 22162 |
| 2922 6427 4497 4116 17658 2581 14364 3781 18851 22974 |
| 10383 2184 1433 3889 12828 17424 17580 20936 1390 21374 |
| 425 2063 22398 20907 9445 14790 4457 723 7048 4072 |
| 11771 9640 23212 9613 12042 8335 21386 20129 13521 16301 |
| 14867 12501 1086 21526 17701 17731 20907 8790 19224 5784 |
| 7107 19690 17616 5800 9501 23320 16878 794 15931 17539 |
| 4556 21783 1524 |
| 20100 11706 23663 |
| 2535 15530 6116 |
| 12078 3867 2663 |
| 19629 20246 7024 |
| 11748 11426 19802 |
| 15942 12333 5316 |
| 11521 3170 17818 |
| 2289 23780 16575 |
| 6649 16991 13025 |
| 20050 10619 10250 |
| 3944 13063 5656 |

| Table 1c : Adresse d'accumulateurs de bit de parité, Débit 1/3, $n_{ldpc}$=32400 |
|---|
| 7416 4093 16722 1023 20586 12219 9175 16284 1554 10113 19849 17545 |
| 13140 3257 2110 13888 3023 1537 1598 15018 18931 13905 10617 1014 |
| 339 14366 3309 15360 18358 3196 4412 6023 7070 17380 2777 6691 |
| 12720 17634 4141 1400 8247 18201 16077 11314 11928 3494 3155 2865 |
| 21038 6928 3860 1943 20292 6526 12939 15182 3957 5651 356 2673 |
| 20555 17905 5724 13932 1218 17763 5912 5164 6233 6220 1277 19209 |
| 19190 4498 4950 6645 5482 5667 13701 16334 15231 735 8589 12344 |

(suite)

| Table 1c : Adresse d'accumulateurs de bit de parité, Débit 1/3, $n_{ldpc}$=32400 |
|---|
| 679 17849 17807 16033 10181 3368 5778 8275 2736 14042 17506 6005 |
| 1576 10259 10525 3007 16522 697 7726 8641 14323 2893 8168 11070 |
| 17270 10180 18740 847 4969 14715 19316 5530 17428 11193 9861 13562 |
| 6156 18787 10467 |
| 2422 3723 10769 |
| 8015 18716 13406 |
| 5969 15949 3084 |
| 6855 13990 3764 |
| 10351 15779 10392 |
| 16078 19034 11279 |
| 11747 6608 4188 |
| 19699 8928 8045 |
| 4598 7219 11391 |
| 19766 11871 5692 |
| 7487 15905 17621 |
| 8554 7751 16516 |
| 4981 20250 16146 |
| 12524 21364 10793 |
| 17083 2051 8862 |
| 1315 6246 7721 |
| 18043 16652 5502 |
| 1432 5674 2224 |
| 11257 1312 8453 |

2. Procédé selon' la revendication 1, dans lequel le code LDPC est d'une structure qui facilite l'utilisation d'une pluralité de moteurs parallèles pour décoder le signal codé.

3. Procédé selon l'une quelconque des revendications 1 à 2, comprenant en outre :

la modulation des trames LDPC codées selon un des types de modulation suivants : $\pi$/2 BPSK, où BPSK est la Modulation par déplacement de phase binaire (Binary Phase Shift Keying) et QPSK, où QPSK est la Modulation par déplacement de phase en quadrature (Quadrature Phase Shift Keying).

4. Procédé selon l'une quelconque des revendications 1 à 3, dans lequel la séquence de données source est segmentée en une série de trames de bande de base, et le procédé comprend en outre :

l'encodage de chaque trame de bande de base sur la base d'un code BCH d'erreur t, où BCH est Bose Chaudhuri Hocquenghem, dans lequel l'encodage BCH comprend un codage externe et l'encodage LDPC comprend un codage interne.

5. Procédé selon la revendication 4, dans lequel le codage externe BCH et le codage interne LDPC sont basés sur une rangée de la table suivante de paramètres de codage en fonction du débit de code :

| Identificateur Code LDPC | Bloc non codé BCH $K_{BCH}$ | Bloc codé BCH $N_{BCH}$ Bloc non codé LDPC $k_{ldpc}$ | Correction d'erreur t BCH | Bloc codé LDPC $n_{ldpc}$ |
|---|---|---|---|---|
| 1/5 | 6300 | 6480 | 12 | 32400 |
| 11/45 | 7740 | 7920 | 12 | 32400 |
| 1/3 | 10620 | 10800 | 12 | 32400 |

6. Procédé selon la revendication 5, dans lequel le codage externe BCH est en outre basé sur la table suivante de polynômes BCH :

| $g_1(x)$ | $1+x^2+x^3+x^5+x^{15}$ |
|---|---|
| $g_2(x)$ | $1+x+x^4+x^7+x^{10}+x^{11}+x^{15}$ |
| $g_3(x)$ | $1+x+x^2+x^4+x^6+x^8+x^{10}+x^{12}+x^{13}+x^{15}$ |
| $g_4(x)$ | $1+x^2+x^3+x^5+x^6+x^8+x^{10}+x^{11}+x^{15}$ |
| $g_5(x)$ | $1+x+x^2+x^4+x^6+x^7+x^{10}+x^{12}+x^{15}$ |
| $g_6(x)$ | $1+x^4+x^6+x^7+x^{12}+x^{13}+x^{15}$ |
| $g_7(x)$ | $1+x^2+x^4+x^5+x^7+x^{11}+x^{12}+x^{14}+x^{15}$ |
| $g_8(x)$ | $1+x^2+x^4+x^6+x^8+x^9+x^{11}+x^{14}+x^{15}$ |
| $g_9(x)$ | $1+x+x^2+x^4+x^5+x^7+x^9+x^{11}+x^{12}+x^{13}+x^{15}$ |
| $g_{10}(x)$ | $1+x+x^2+x^3+x^4+x^7+x^{10}+x^{11}+x^{12}+x^{13}+x^{15}$ |
| $g_{11}(x)$ | $1+x+x^2+x^4+x^9+x^{11}+x^{15}$ |
| $g_{12}(x)$ | $1+x^2+x^4+x^8+x^{10}+x^{11}+x^{13}+x^{15}$ |

7. Appareil pour encoder, comprenant :

au moins un processeur ; et
au moins une mémoire incluant un code de programme informatique pour un ou plusieurs programmes, la au moins une mémoire et le code de programme informatique configurés pour, avec le au moins un processeur, amener l'appareil à effectuer au moins ce qui suit :
l'encodage d'une séquence de données source de bits d'information sur la base d'une matrice de contrôle de parité structurée prédéterminée d'un code LDPC, où LDPC est un Contrôle de Parité à faible densité (Low Density Parity Check), où l'encodage est effectué sur la base de trames de la séquence de données source, chaque trame étant d'une longueur de $k_{ldpc}$ bits d'information $i_0, i_1,..., i_{k_{ldpc}-1}$, et la sortie de l'encodage comprend des trames LDPC codées, chacune étant de $n_{ldpc}$ bits codés de longueur, où $n_{ldpc}$ = 32400 et
dans lequel la matrice de contrôle de parité structurée est représentée par des informations tabulaires d'un format dans lequel chaque rangée représente des occurrences d'une valeur à l'intérieur d'une colonne respective de la matrice de contrôle de parité, et les colonnes de la matrice de contrôle de parité sont dérivées selon une opération prédéterminée sur la base des rangées respectives des informations tabulaires, et dans lequel les informations tabulaires comprennent une des Tables **2a** à **2c ;**
dans lequel l'encodage comprend la génération de $n_{ldpc} - k_{ldpc}$ bits de parité $p_0, p_1,..., p_{n_{ldpc}-k_{ldpc}-1}$ pour chaque trame de la séquence de données source, dans lequel la génération des bits de parité comprend :

l'initialisation d'accumulateurs de bit de parité pour $p_0, p_1,..., p_{n_{ldpc}-k_{ldpc}-1}$ à zéro ;
l'accumulation de bit d'information $i_0$ à des adresses d'accumulateur de bit de parité spécifiées dans la première rangée des informations tabulaires ;
pour le groupe suivant de $m$ - 1 bits d'information $i_y$, où $y$ = 1, 2, ...,$m$ - 1 , l'accumulation de chaque bit d'information à des adresses d'accumulateur de bit de parité $\{x + (y \bmod m) * q\} \bmod (n_{ldpc} - k_{ldpc})$, où $x$ désigne une adresse d'un accumulateur de bit de parité correspondant au bit d'information $i_0$, et $q$ est une constante dépendante du débit de code, où $q = (n_{ldpc} - k_{ldpc})/m$ et où $m$ est une constante dépendante du code qui est égale à 360 et $k_{ldpc} = R * n_{ldpc}$, où $R$ le débit de code ;
l'accumulation d'$i_m$ à des adresses d'accumulateur de bit de parité spécifiées dans la deuxième rangée des informations tabulaires, et, d'une manière similaire à celle pour le groupe de $m$ - 1 bits d'information, l'accumulation de chaque bit d'information du groupe suivant de $m$ - 1 bits d'information $i_z$, $z = m + 1$, $m + 2,..., 2m$ à $\{x + (z \bmod m) * q\} \bmod (n_{ldpc} - k_{ldpc})$, où $x$ désigne l'adresse de l'accumulateur de bit de parité correspondant au bit d'information $i_m$ ;
de manière similaire, pour chaque groupe subséquent de $m$ bits d'information, l'accumulation des bits d'information à des adresses de bit de parité sur la base d'une rangée suivante des informations tabulaires ; et

après que tous les bits d'information de la trame sont accumulés, l'exécution d'opérations selon $p_i = p_i \oplus p_{i-1}$, où pour $i = 1,2,..., (n_{ldpc} - k_{ldpc} -1)$, chaque $p_i$ résultant de l'opération pour un $i$ donné est égal au bit de parité $p_i$ ;

| Table 2a : Adresse d'accumulateurs de bit de parité, Débit 1/5, $n_{ldpc}$=32400 |
| --- |
| 18222 6715 4908 21568 22821 11708 4769 4495 22243 25872 9051 19072 13956 |
| 2038 5205 21215 21009 9584 2403 23652 20866 20130 677 9509 6136 773 |
| 19936 14590 17829 473 4432 23171 11386 17937 22084 24450 267 8822 19335 |
| 16376 16769 5111 9794 18907 827 12385 12370 21647 10938 23619 11633 15865 |
| 23417 7631 12243 21546 4192 22117 14757 4118 9686 17021 8531 15989 8807 |
| 15533 16584 18529 19699 17821 4252 1254 5952 3163 20295 6944 1022 19743 |
| 129 16579 23524 25897 14690 11222 16250 9925 4268 999 7102 24528 152 |
| 18361 3708 3454 16604 1551 5809 20324 4775 22418 19091 19674 10975 7327 |
| 24133 10950 22779 11388 13818 20668 7556 12333 16446 19684 12510 25118 8162 |
| 17026 6850 1269 |
| 21895 7137 25270 |
| 11858 24153 13303 |
| 7885 16438 12805 |
| 10473 15004 8052 |
| 2088 10379 10067 |
| 21438 13426 10440 |
| 17696 727 12164 |
| 22623 8408 17849 |

| Table 2b : Adresse d'accumulateurs de bit de parité, Débit 11/45, $n_{ldpc}$=32400 |
| --- |
| 20617 6867 14845 11974 22563 190 17207 4052 7406 16007 |
| 21448 14846 2543 23380 16633 20365 16869 13411 19853 795 |
| 5200 2330 2775 23620 20643 10745 14742 6493 14222 20939 |
| 9445 9523 12769 7332 21792 18717 16397 14016 9481 22162 |
| 2922 6427 4497 4116 17658 2581 14364 3781 18851 22974 |
| 10383 2184 1433 3889 12828 17424 17580 20936 1390 21374 |
| 425 2063 22398 20907 9445 14790 4457 723 7048 4072 |
| 11771 9640 23212 9613 12042 8335 21386 20129 13521 16301 |
| 14867 12501 1086 21526 17701 17731 20907 8790 19224 5784 |
| 7107 19690 17616 5800 9501 23320 16878 794 15931 17539 |
| 4556 21783 1524 |
| 20100 11706 23663 |
| 2535 15530 6116 |
| 12078 3867 2663 |
| 19629 20246 7024 |
| 11748 11426 19802 |
| 15942 12333 5316 |
| 11521 3170 17818 |
| 2289 23780 16575 |
| 6649 16991 13025 |
| 20050 10619 10250 |
| 3944 13063 5656 |

| Table 2c : Adresse d'accumulateurs de bit de parité, Débit 1/3, $n_{ldpc}$=32400 |
|---|
| 7416 4093 16722 1023 20586 12219 9175 16284 1554 10113 19849 17545 |
| 13140 3257 2110 13888 3023 1537 1598 15018 18931 13905 10617 1014 |
| 339 14366 3309 15360 18358 3196 4412 6023 7070 17380 2777 6691 |
| 12720 17634 4141 1400 8247 18201 16077 11314 11928 3494 3155 2865 |
| 21038 6928 3860 1943 20292 6526 12939 15182 3957 5651 356 2673 |
| 20555 17905 5724 13932 1218 17763 5912 5164 6233 6220 1277 19209 |
| 19190 4498 4950 6645 5482 5667 13701 16334 15231 735 8589 12344 |
| 679 17849 17807 16033 10181 3368 5778 8275 2736 14042 17506 6005 |
| 1576 10259 10525 3007 16522 697 7726 8641 14323 2893 8168 |

11070
17270 10180 18740 847 4969 14715 19316 5530 17428 11193
9861 13562
6156 18787 10467
2422 3723 10769
8015 18716 13406
5969 15949 3084
6855 13990 3764
10351 15779 10392
16078 19034 11279
11747 6608 4188
19699 8928 8045
4598 7219 11391
19766 11871 5692
7487 15905 17621
8554 7751 16516
4981 20250 16146
12524 21364 10793
17083 2051 8862
1315 6246 7721
18043 16652 5502
1432 5674 2224
11257 1312 8453

8. Appareil selon la revendication 7, dans lequel le code LDPC est d'une structure qui facilite l'utilisation d'une pluralité de moteurs parallèles pour décoder le signal codé.

9. Appareil selon l'une quelconque des revendications 7 à 8, dans lequel l'appareil est amené à effectuer en outre :

la modulation des trames LDPC codées selon un des types de modulation suivants : $\pi$/2 BPSK, où BPSK est la Modulation par déplacement de phase binaire (Binary Phase Shift Keying), et QPSK, où QPSK est la Modulation par déplacement de phase en quadrature (Quadrature Phase Shift Keying).

10. Appareil selon l'une quelconque des revendications 7 à 9, dans lequel la séquence de données source est segmentée en une série de trames de bande de base, et l'appareil est amené à effectuer en outre :

l'encodage de chaque trame de bande de base sur la base d'un code BCH d'erreur t, où BCH est Bose Chaudhuri Hocquenghem, dans lequel l'encodage BCH comprend un codage externe et l'encodage LDPC comprend un codage interne.

11. Appareil selon la revendication 10, dans lequel le codage externe BCH et le codage interne LDPC sont basés sur une rangée de la table suivante de paramètres de codage en fonction du débit de code :

| Identificateur Code LDPC | Bloc non codé BCH $K_{BCH}$ | Bloc codé BCH $N_{BCH}$ Bloc non codé LDPC $k_{ldpc}$ | Correction d'erreur t BCH | Bloc codé LDPC $n_{ldpc}$ |
|---|---|---|---|---|
| 1/5 | 6300 | 6480 | 12 | 32400 |
| 11/45 | 7740 | 7920 | 12 | 32400 |
| 1/3 | 10620 | 10800 | 12 | 32400 |

**12.** Appareil selon la revendication 11, dans lequel le codage externe BCH est en outre basé sur la table suivante de polynômes BCH :

| | |
|---|---|
| $g_1(x)$ | $1+x^2+x^3+x^5+x^{15}$ |
| $g_2(x)$ | $1+x+x^4+x^7+x^{10}+x^{11}+x^{15}$ |
| $g_3(x)$ | $1+x^2+x^4+x^6+x^8+x^{10}+x^{12}+x^{13}+x^{15}$ |
| $g_4(x)$ | $1+x^2+x^3+x^5+x^6+x^8+x^{10}+x^{11}+x^{15}$ |
| $g_5(x)$ | $1+x+x^2+x^4+x^6+x^7+x^{10}+x^{12}+x^{15}$ |
| $g_6(x)$ | $1+x^4+x^6+x^7+x^{12}+x^{13}+x^{15}$ |
| $g_7(x)$ | $1+x^2+x^4+x^5+x^7+x^{11}+x^{12}+x^{14}+x^{15}$ |
| $g_8(x)$ | $1+x^2+x^4+x^6+x^8+x^9+x^{11}+x^{14}+x^{15}$ |
| $g_9(x)$ | $1+x+x^2+x^4+x^5+x^7+x^9+x^{11}+x^{12}+x13+x^{15}$ |
| $g_{10}(x)$ | $1+x+x^2-x^3-x^4+x^5+x^{10}-x^{11}+x^{12}+x^{13}+x^{15}$ |
| $g_{11}(x)$ | $1+x+x^2+x^4+x^9+x^{11}+x^{15}$ |
| $g_{12}(x)$ | $1+x^2+x^4+x^8+x^{10}+x^{11}+x^{13}+x^{14}+x^{15}$ |

**13.** Programme informatique avec des moyens de code de programme afin d'effectuer toutes les étapes selon l'une quelconque des revendications 1 à 6, lorsque le programme s'exécute sur un ordinateur ou un processeur de signal numérique.

# FIG. 1A

110

TRANSMITTER
112

CHANNEL
114

RECEIVER
116

FIG. 1B

# FIG. 2A

EP 2 822 182 B1

EP 2 822 182 B1

## FIG. 2B

RECEIVER 220

SYNC MODULE
227

DEMODULATOR
225

DECODER
223

DATA
DE-ENCAPSULATION
221

229

FIG. 3A
(Prior Art)

FIG. 3B
(Prior Art)

FIG. 4
(Prior Art)

## FIG. 5

### π/2 BPSK

EP 2 822 182 B1

600

START

611 — RECEIVED SOURCE DATA
SEQUENCE

613 — ENCAPSULATE SOURCE DATA
SEQUENCE TO FORM SEQUENCE
OF BASEBAND FRAMES

615 — ENCODE BASEBAND FRAMES
BASED ON BCH CODE TO
GENERATE CODED BCH FRAMES
(OUTER CODING)

617 — ENCODE CODED BCH FRAMES
BASED ON LDPC CODE TO
GENERATE CODED LDPC FRAMES
(INNER CODING)

619 — INTERLEAVE CODED LDPC FRAMES
TO GENERATE CODED FEC
FRAMES

621 — MODULATE CODED FEC FRAMES
FOR TRANSMISSION OVER
WIRELESS CHANNEL

END

FIG. 6

700

START

711 — RECEIVED TRANSMITTED DATA SIGNAL

713 — DETECT UNIQUE WORD HEADER AND ACQUIRE SYNCHRONIZATION

715 — DECODE HEADER AND DETERMINE MODULATION SCHEME AND CODING SCHEME (INTERLEAVING METHOD, LDPC INNER CODING AND BCH OUTER CODING) APPLIED AT TRANSMITTER

717 — DEMODULATE RECEIVED DATA SIGNAL BASED ON DETERMINED MODULATION SCHEME

719 — DE-INTERLEAVE DEMODULATED DATA SIGNALS BASED ON DETERMINED INTERLEAVING METHOD

721 — DECODE DATA SIGNALS BASED ON DETERMINED LDPC INNER CODING

723 — DECODE DATA SIGNALS BASED ON DETERMINED BCH OUTER CODING

725 — REGENERATE SOURCE DATA SEQUQNCE BASED ON DEMODULATED AND DECODED DATA SIGNAL

END

FIG. 7

# FIG. 8

800

PROCESSOR
803

DSP
807

ASIC
809

BUS 801

MEMORY
805

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 327316 A

- US 13890643 B